# EUROPEAN PATENT APPLICATION

(11) **EP 4 503 896 A1**
(43) Date of publication of application: **05.02.2025**
(21) Application number: 24187478.3
(22) Date of filing: 09.07.2024
(51) Int. Cl.: H10K 59/122, H10K 59/131, H10K 59/80

(54) **DISPLAY DEVICE AND METHOD OF FABRICATING THE SAME**

(30) Priority: 31.07.2023 KR 20230099641
(71) Applicant: Samsung Display Co., Ltd., Gyeonggi-do 17113 (KR)
(72) Inventor: LEE, Jeong Seok, Yongin-si (KR); SUNG, Woo Yong, Yongin-si (KR); YANG, Hee Jun, Yongin-si (KR)
(74) Representative: Marks & Clerk LLP

(57) **Abstract**

DISPLAY DEVICE AND METHOD OF FABRICATING THE SAME

A display device includes: a substrate including an emission area and a non-emission area; a pixel electrode located on the emission area of the substrate; a pixel defining layer located on the pixel electrode, overlapping the non-emission area, and defining a first opening therein; a bank structure located on the pixel defining layer and defining a second opening therein; an auxiliary electrode located on the bank structure and including a conductive material; and a common electrode located on the pixel electrode and contacting the auxiliary electrode in the second opening, where the bank structure includes a first bank layer and a second bank layer, which includes different conductive materials from each other, the second bank layer includes a tip protruding toward the first opening from a side surface of the first bank layer, and the auxiliary electrode completely covers the protruding tip of the second bank layer.

## Description

### BACKGROUND

### 1. Field

The present disclosure relates to a display device and a method of fabricating the same.

### 2. Description of the Related Art

As the information society develops, demands for display devices for displaying images are increasing in various forms. For example, display devices are applied to various electronic devices such as smartphones, digital cameras, notebook computers, navigation devices, and smart televisions. The display devices may be flat panel display devices such as liquid crystal display devices, field emission display devices, and organic light emitting display devices. Among these flat panel display devices, a light emitting display device includes a light emitting element that enables each pixel of a display panel to emit light by itself. Thus, the light emitting display device can display an image without a backlight unit that provides light to the display panel.

### SUMMARY

Aspects of the present disclosure provide a display device which physically protects a bank structure during a fabrication process.

Aspects of the present disclosure also provide a display device with reduced driving resistance.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

In an embodiment of the disclosure, a display device includes: a substrate including an emission area and a non-emission area; a first pixel electrode located on the emission area of the substrate; a pixel defining layer located on the first pixel electrode, overlapping the non-emission area, and defining a first opening therein; a bank structure located on the pixel defining layer and defining a second opening therein; an auxiliary electrode located on the bank structure and including a conductive material; and a first common electrode located on the first pixel electrode and contacting the auxiliary electrode in the second opening, where the bank structure includes a first bank layer and a second bank layer including different conductive materials from each other, the second bank layer includes a tip protruding toward the first opening from a side surface of the first bank layer, and the auxiliary electrode completely covers the protruding tip of the second bank layer.

In an embodiment, the second bank layer may include a first surface facing the substrate, a second surface facing the first surface, and a side surface opposite to the first opening and connecting the first surface and the second surface, and the auxiliary electrode overlaps the protruding tip of the second bank layer to contact the first surface, the side surface, and the second surface.

In an embodiment, the auxiliary electrode may contact and completely cover the second surface of the second bank layer.

In an embodiment, the auxiliary may electrode contact and completely cover the side surface of the first bank layer.

In an embodiment, the bank structure may be completely surrounded by the pixel defining layer and the auxiliary electrode.

In an embodiment, the auxiliary electrode may be a crystallized transparent oxide.

In an embodiment, the first bank layer includes aluminium (Al), and the second bank layer may include titanium (Ti).

In an embodiment, a display device may further include a first light emitting layer located between the first pixel electrode and the first common electrode, where the first light emitting layer contacts the auxiliary electrode in the second opening.

In an embodiment, the auxiliary electrode may include a first portion in contact with the first light emitting layer and a second portion in contact with the first common electrode, and a width of the second portion is greater than a width of the first portion in a direction perpendicular to a major surface of the substrate.

In an embodiment, a display device may further include an organic pattern overlapping the protruding tip of the second bank layer, located on the auxiliary electrode, and including the same material as the first light emitting layer; and an electrode pattern located on the organic pattern and including the same material as the first common electrode, where the organic pattern is spaced apart from the first light emitting layer, and the electrode pattern is spaced apart from the first common electrode.

In an embodiment, a display device may further include a first encapsulation layer located on the first common electrode and the electrode pattern, where the first encapsulation layer contacts the auxiliary electrode on the side surface of the first bank layer.

In an embodiment, a display device may further include a pattern located between the pixel defining layer and the first pixel electrode and overlapping the protruding tip of the second bank layer in a direction perpendicular to a major surface of the substrate, where the pattern overlaps the auxiliary electrode in the direction perpendicular to the major surface of the substrate.

In an embodiment of the disclosure, a display device includes: a substrate including a first emission area, a second emission area, and a non-emission area located between the first emission area and the second emission area; a first pixel electrode overlapping the first emission area and located on the substrate; a pixel defining layer overlapping the non-emission area and located on the first pixel electrode; a second pixel electrode overlapping the second emission area and spaced apart from the first pixel electrode with the pixel defining layer interposed therebetween; a bank structure located on the pixel defining layer; and an auxiliary electrode located on the pixel defining layer and the bank structure, where the auxiliary electrode includes: a first portion overlapping the first emission area; a second portion overlapping the second emission area; and a third portion overlapping the non-emission area, and the first portion and the second portion of the auxiliary electrode are extended from the third portion, and the third portion of the auxiliary electrode completely covers an upper surface of the bank structure.

In an embodiment, the bank structure may include: a first bank layer and a second bank layer, the second bank layer may include tips, which protrude from side surfaces of the first bank layer toward the first emission area and the second emission area, respectively, and the first portion and the second portion of the auxiliary electrode completely cover the protruding tips of the second bank layer, respectively.

In an embodiment, a display device may further include: a first common electrode located on the first pixel electrode; and a second common electrode located on the second pixel electrode, where the first common electrode and the second common electrode may be spaced apart from each other with the bank structure interposed therebetween, the first common electrode may contact the first portion of the auxiliary electrode, and the second common electrode may contact the second portion of the auxiliary electrode.

In an embodiment, a display device may further include: a first inorganic layer covering the first common electrode; and a second inorganic layer covering the second common electrode, where the first inorganic layer and the second inorganic layer may overlap the third portion of the auxiliary electrode and are spaced apart from each other.

In an embodiment, a display device may further include: an organic encapsulation layer located on the first inorganic layer and the second inorganic layer, where the third portion of the auxiliary electrode may contact the organic encapsulation layer.

In an embodiment of the disclosure, a method of fabricating a display device includes: forming a plurality of pixel electrodes spaced apart from each other on a substrate, a sacrificial layer disposed on the pixel electrodes, a pixel defining layer disposed on the sacrificial layer, and a first bank material layer and a second bank material layer disposed on the pixel defining layer; forming first holes overlapping the pixel electrodes and passing through the first bank material layer and the second bank material layer to expose the pixel defining layer disposed on the pixel electrodes; forming tips of the second bank material layer, which protrude from sidewalls of the first bank material layer through wet-etching sidewalls of the first holes; forming an auxiliary electrode material layer covering the pixel defining layer, the first bank material layer, and the second bank material layer; forming openings by removing portions of the auxiliary electrode material layer, which overlap the pixel electrodes through wet etching, removing portions of the pixel defining layer, which overlap the pixel electrodes through dry etching and removing portions of the sacrificial layer, which overlap the pixel electrodes through wet etching and exposing the pixel electrodes overlapping the openings; performing high-temperature heat treatment on the auxiliary electrode material layer covering the first bank material layer and the second bank material layer; forming a light emitting layer and a common electrode on each of the pixel electrodes in the openings and forming an inorganic layer on the common electrode and the auxiliary electrode material layer; and partially removing portions of the inorganic layer, which are disposed on the auxiliary electrode material layer, where the auxiliary electrode material layer completely covers the protruding tips of the second bank material layer.

In an embodiment, the auxiliary electrode material layer may become a crystallized transparent oxide through the high-temperature heat treatment.

In an embodiment, the first bank material layer and the second bank material layer may be completely surrounded by the pixel defining layer and the auxiliary electrode material layer.

At least some of the above and other features of the invention are set out in the claims.

A display device according to an embodiment may include an auxiliary electrode covering a bank structure. Etching of the bank structure can be prevented during a process of fabricating the display device, and driving resistance of the display device can be reduced.

It should be noted that effects of the present disclosure are not limited to those described above and other effects of the present disclosure will be apparent to those skilled in the art from the following descriptions.

### BRIEF DESCRIPTION OF THE DRAWINGS

These and/or other aspects will become apparent and more readily appreciated from the following description of the embodiments, taken in conjunction with the accompanying drawings in which:
FIG. 1 is a perspective view of a display device according to an embodiment;
FIG. 2 is a plan view of a display panel and display drivers according to an embodiment;
FIG. 3 is a perspective view of a display device according to an embodiment;
FIG. 4 is a cross-sectional view of the display device taken along line Y1-Y1' of FIG. 1;
FIG. 5 is a cross-sectional view of the display device of FIG. 4 in which a bending area is bent;
FIG. 6 is a plan view illustrating the arrangement of emission areas in a display area;
FIG. 7 is a cross-sectional view of the display device taken along line X1-X1' of FIG. 6;
FIG. 8 is an enlarged cross-sectional view of a first emission area of FIG. 7;
FIG. 9 is an enlarged cross-sectional view of area 'A' of FIG. 7;
FIG. 10 is an enlarged cross-sectional view of a first portion of an auxiliary electrode of FIG. 9;
FIG. 11 is an enlarged cross-sectional view of a second portion of the auxiliary electrode of FIG. 9;
FIG. 12 is an enlarged plan view of area 'Q' of FIG. 2;
FIG. 13 is a cross-sectional view of the display device taken along line Q1-Q1' of FIG. 12; and
FIGS. 14 through 24 are cross-sectional views sequentially illustrating a portion of a display area during a process of fabricating a display device according to an embodiment.

### DETAILED DESCRIPTION

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. The same reference numbers indicate the same components throughout the specification. In the attached figures, the thickness of layers and regions is exaggerated for clarity.

It will also be understood that when a layer is referred to as being "on" another layer or substrate, it can be directly on the other layer or substrate, or intervening layers may also be present. In contrast, when an element is referred to as being "directly on" another element, there are no intervening elements present. Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

Each of the various embodiments of the present invention may be partially or wholly capable of combining or combining with each other, technically various interlocking and driving are possible, and each embodiment may be able to be performed independently with respect to each other or may be implemented together in an association relationship.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value. Hereinafter, embodiments of the present disclosure will be described with reference to the accompanying drawings.

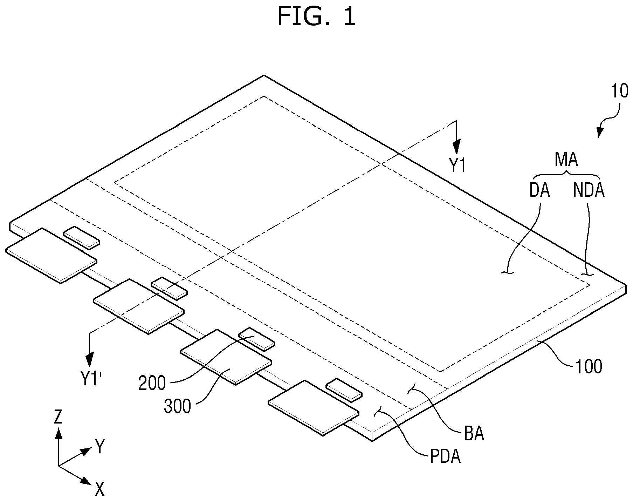

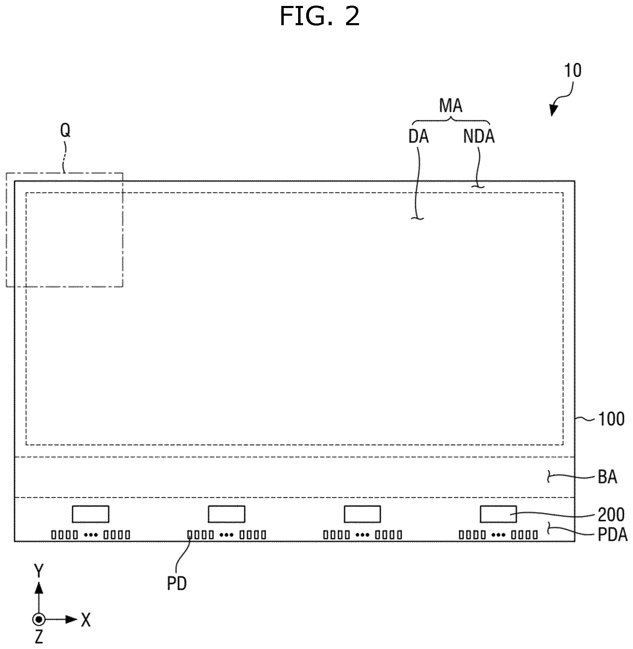

FIG. 1 is a perspective view of a display device 10 according to an embodiment. FIG. 2 is a plan view of a display panel 100 and display drivers 200 according to an embodiment. As used herein, the "plan view" is a view in a thickness direction (Z-axis direction) of the substrate 110.

Referring to FIGS. 1 and 2, the display device 10 according to the embodiment is a device for displaying moving images or still images. The display device 10 may be used as a display screen in portable electronic devices such as mobile phones, smartphones, tablet personal computers ("PCs"), smart watches, watch phones, mobile communication terminals, electronic notebooks, electronic books, portable multimedia players ("PMPs"), navigation devices and ultra-mobile PCs ("UMPCs"), as well as in various products such as televisions, notebook computers, monitors, billboards and Internet of things ("IoT") devices.

The display device 10 according to the embodiment may be a light emitting display device such as an organic light emitting display device using an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. A case where the display device 10 is an organic light emitting display device will be mainly described below, but the present disclosure is not limited thereto.

The display device 10 according to the embodiment may include the display panel 100, the display drivers 200, and circuit boards 300.

The display panel 100 may be shaped like a rectangular plane having long sides in a first direction (X-axis direction) and short sides in a second direction (Y-axis direction) crossing the first direction (X-axis direction). Each corner where a long side extending in the first direction (X-axis direction) meets a short side extending in the second direction (Y-axis direction) may be right-angled or may be rounded with a curvature. The planar shape of the display panel 100 is not limited to a quadrangular shape and may also be another polygonal shape, a circular shape, or an oval shape. In the drawings, the first direction (X-axis direction) and the second direction (Y-axis direction) are horizontal directions crossing each other. For example, the first direction (X-axis direction) and the second direction (Y-axis direction) may be orthogonal to each other. In addition, a third direction (Z-axis direction) may cross the first direction (X-axis direction) and the second direction (Y-axis direction), for example, may be a vertical direction orthogonal to the first direction (X-axis direction) and the second direction (Y-axis direction). In the present specification, a direction indicated by an arrow of each of the first to third directions (X-axis, Y-axis and Z-axis directions) may be referred to as one side, and the opposite direction may be referred to as the other side.

The display panel 100 may be formed flat, but the present disclosure is not limited thereto. For another example, the display panel 100 may include curved portions formed at left and right ends and having a constant or varying curvature. In addition, the display panel 100 may be formed to be flexible so that it can be curved, bent, folded, or rolled.

The display panel 100 may include a main area MA, a bending area BA, and a pad area PDA. The main area MA may include a display area DA displaying an image and a non-display area NDA disposed around the display area DA.

The display area DA may occupy most of the area of the display panel 100. The display area DA may be disposed in a center of the display panel 100. Pixels including emission areas, respectively, may be disposed in the display area DA to display an image.

The non-display area NDA may neighbor the display area DA. The non-display area NDA may be an area outside the display area DA. The non-display area NDA may surround the display area DA. The non-display area NDA may be an edge area of the display panel 100.

The bending area BA may be disposed between the display area DA and the pad area PDA in the second direction (Y-axis direction). The bending area BA may extend in the first direction (X-axis direction). The bending area BA is an area bent toward the bottom of the display panel 100. When the bending area BA is bent toward the bottom of the display panel 100, the display drivers 200 and the circuit boards 300 may be disposed under the display panel 100.

The pad area PDA may be a lower edge area of the display panel 100. The pad area PDA may include the display drivers 200, display pads PD, and the circuit boards 300.

The display drivers 200 may be disposed in the pad area PDA. The display drivers 200 may be disposed in the non-display area NDA between the display pads PD and the display area DA. Each of the display drivers 200 may be attached to the non-display area NDA of the display panel 100 using a chip on glass ("COG") method. In an embodiment, each of the display drivers 200 may also be attached to a circuit board 300 using a chip on plastic ("COP") method.

The circuit boards 300 may be disposed on the display pads PD disposed on an edge of the display panel 100. The circuit boards 300 may be attached to the display pads PD using a conductive adhesive member such as an anisotropic conductive film or an anisotropic conductive adhesive. Therefore, the circuit boards 300 may be electrically connected to signal lines of the display panel 100. Each of the circuit boards 300 may be a flexible printed circuit board or a flexible film such as a chip on film.

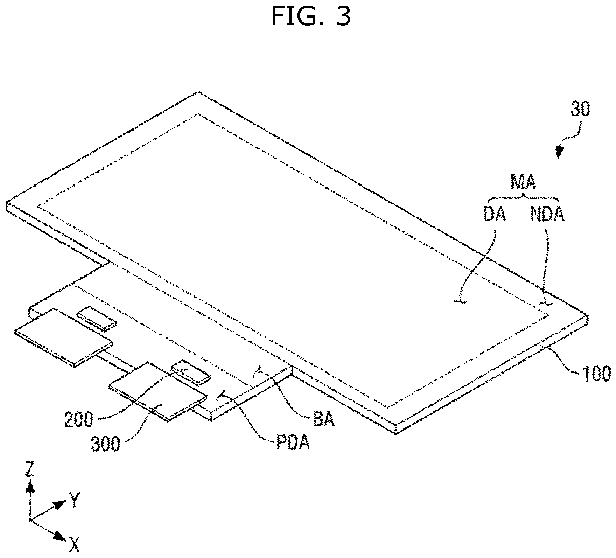

FIG. 3 is a perspective view of a display device 30 according to an embodiment.

Referring to FIG. 3, the shape of a display panel 100 included in the display device 30 may be different from the shape of the display panel 100 included in the display device 10. In an embodiment, for example, in the display panel 100 included in the display device 30, a length of a main area MA in the first direction (X-axis direction) may be greater than lengths of a bending area BA and a pad area PDA in the first direction (X-axis direction). The bending area BA and the pad area PDA may protrude from a portion of a side of the main area MA. The shape of the display panel 100 is not limited to the shapes illustrated in FIGS. 1 through 3 and may vary according to the type of display device 10.

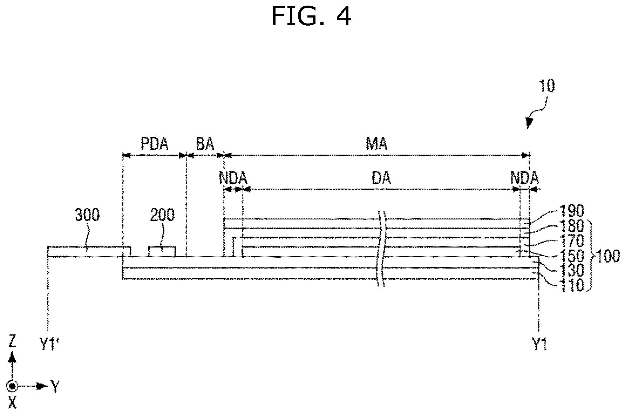

FIG. 4 is a cross-sectional view of a side of the display device 10 taken along line Y1-Y1' of FIG. 1.

Referring to FIG. 4, the display device 10 may include the display panel 100, a color filter layer 190, a display driver 200, and a circuit board 300. The display panel 100 may include a substrate 110, a thin-film transistor layer 130, a light emitting element layer 150, a thin-film encapsulation layer 170, and a touch sensor layer 180.

The substrate 110 may be a base substrate or a base member. The substrate 110 may be a flexible substrate that can be bent, folded, rolled, etc. In an embodiment, for example, the substrate 110 may include polymer resin such as polyimide ("PI"), but the present disclosure is not limited thereto. For another example, the substrate 110 may include a glass material or a metal material.

The thin-film transistor layer 130 may be disposed on the substrate 110. The thin-film transistor layer 130 may include a plurality of thin-film transistors. Each of the thin-film transistors may include a semiconductor region, a source electrode, a drain electrode, and a gate electrode. In addition, the thin-film transistor layer 130 may further include gate lines, data lines, power lines, gate control lines, fan-out lines connecting the display driver 200 and the data lines, and lead lines connecting the display driver 200 and a pad unit. In an embodiment, for example, when a gate driver is disposed on a side of the non-display area NDA of the display panel 100, it may include thin-film transistors.

The thin-film transistor layer 130 may be disposed in the main area MA, the bending area BA, and the pad area PDA. The thin-film transistors, the gate lines, the data lines, and the power lines of the thin-film transistor layer 130 may be disposed in the display area DA of the main area MA. The gate control lines and the fan-out lines of the thin-film transistor layer 130 may be disposed in the non-display area NDA of the main area MA. In addition, the lead lines of the thin-film transistor layer 130 may be disposed in the bending area BA and the pad area PDA.

The light emitting element layer 150 may be disposed on the thin-film transistor layer 130. The light emitting element layer 150 may include a plurality of light emitting elements, each including a pixel electrode, a light emitting layer and a common electrode to emit light, a pixel defining layer, and a bank structure.

In an embodiment, the light emitting layer may be an organic light emitting layer including an organic material. The light emitting layer may include a hole transporting layer, an organic light emitting layer, and an electron transporting layer. When the pixel electrode receives a voltage through a thin-film transistor of the thin-film transistor layer 130 and the common electrode receives a cathode voltage, holes and electrons may move to the organic light emitting layer through the hole transporting layer and the electron transporting layer, respectively. Then, the holes and the electrons may be combined with each other in the organic light emitting layer to emit light. In an embodiment, each of the light emitting elements may include a quantum dot light emitting diode including a quantum dot light emitting layer, an inorganic light emitting diode including an inorganic semiconductor, or a micro-light emitting diode.

The thin-film encapsulation layer 170 may cover upper and side surfaces of the light emitting element layer 150 and may protect the light emitting element layer 150. The thin-film encapsulation layer 170 may include at least one inorganic layer and at least one organic layer to encapsulate the light emitting element layer 150.

The touch sensor layer 180 may be disposed on the thin-film encapsulation layer 170. The touch sensor layer 180 may include a plurality of touch electrodes and a plurality of touch lines for sensing a user's touch in a capacitive manner. In an embodiment, for example, the touch sensor layer 180 may sense a user's touch in a mutual capacitance manner or a self-capacitance manner. The touch electrodes of the touch sensor layer 180 may be disposed in a touch sensor area overlapping the display area DA. The touch lines of the touch sensor layer 180 may be disposed in a touch peripheral area overlapping the non-display area NDA.

The color filter layer 190 may be disposed on the touch sensor layer 180. The color filter layer 190 may include a plurality of color filters corresponding to a plurality of emission areas, respectively. Each of the color filters may selectively transmit light of a specific wavelength and block or absorb light of other wavelengths. The color filter layer 190 may absorb a part of light coming from the outside of the display device 10, thereby reducing reflected light due to the external light. Therefore, the color filter layer 190 can prevent color distortion due to reflection of external light.

Since the color filter layer 190 is directly disposed on the touch sensor layer 180, the display device 10 may not require a separate substrate for the color filter layer 190.

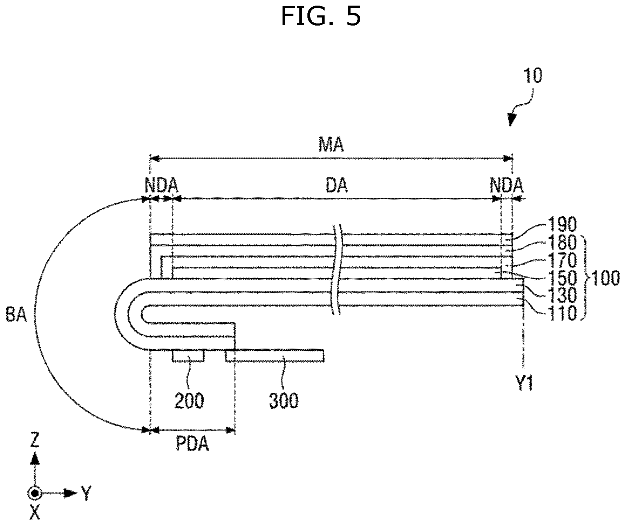

Referring to FIG. 5, the pad area PDA of the display device 10 may be bent by the bending area BA. When the pad area PDA is bent by the bending area BA, the display driver 200 and the circuit board 300 located in the pad area PDA may be overlapped by the main area MA in the third direction (Z-axis direction).

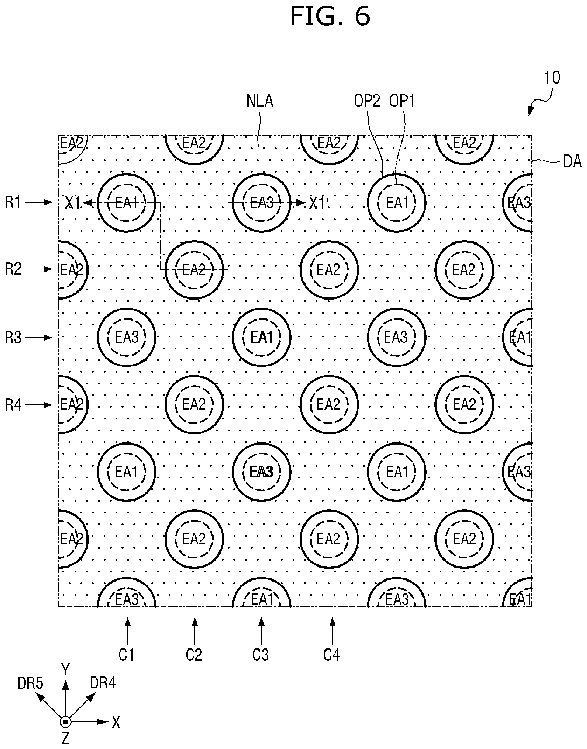

FIG. 6 is a plan view illustrating the arrangement of emission areas EA1 through EA3 in the display area DA.

Referring to FIG. 6, the display device 10 may include a plurality of emission areas EA1 through EA3 and a non-emission area NLA disposed in the display area DA.

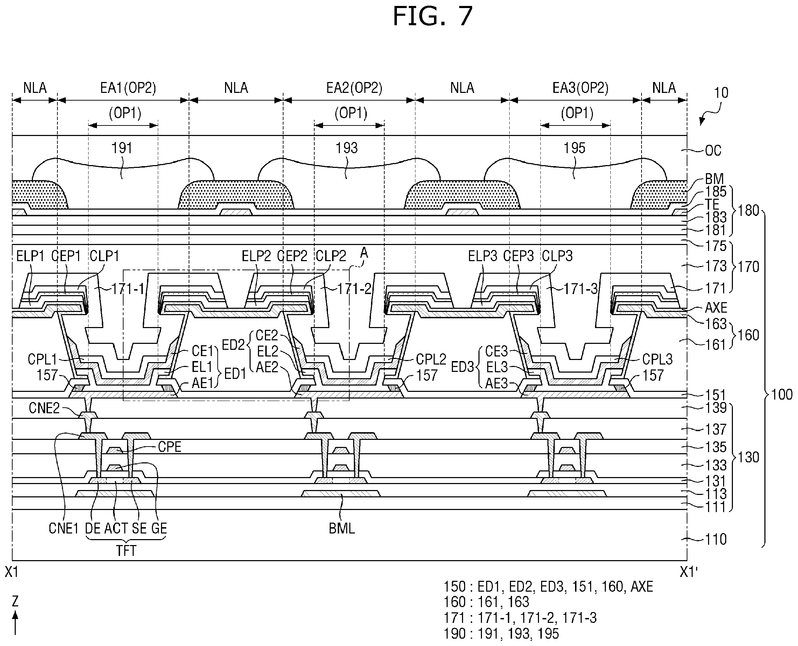

The emission areas EA1 through EA3 may include first emission areas EA1, second emission areas EA2, and third emission areas EA3 emitting light of different colors. Each of the emission areas EA1 through EA3 may emit red, green or blue light, and the color of light emitted from each of the emission areas EA1 through EA3 may vary according to the type of light emitting element ED 1, ED2 or ED3 (see FIG. 7) which will be described later. In an embodiment, the first emission areas EA1 may emit red first light, the second emission areas EA2 may emit green second light, and the third emission areas EA3 may emit blue third light. However, the present disclosure is not limited thereto.

The emission areas EA1 through EA3 may be arranged in a PenTile^{™} type, for example, a diamond PenTile^{™} type. In an embodiment, for example, the first emission areas EA1 and the third emission areas EA3 may be spaced apart from each other in the first direction X and may be alternately disposed in the first direction X and the second direction Y. In the arrangement of the emission areas EA1 through EA3, the first emission areas EA1 and the third emission areas EA3 may be alternately disposed in the first direction X in a first row R1 and a third row R3. The first emission areas EA1 and the third emission areas EA3 may be alternately disposed in the second direction Y in a first column C1 and a third column C3.

Each of the second emission areas EA2 may be spaced apart from other adjacent second emission areas EA2 in the first direction X and the second direction Y and may be spaced apart from adjacent first and third emission areas EA1 and EA3 in a fourth direction DR4 or a fifth direction DR5. The second emission areas EA2 may be repeatedly disposed along the first direction X and the second direction Y. The second emission areas EA2 and the first emission areas EA1 or the second emission areas EA2 and the third emission areas EA3 may be alternately disposed along the fourth direction DR4 or the fifth direction DR5. In the arrangement of the emission areas EA1 through EA3, the second emission areas EA2 may be repeatedly disposed in the first direction X in a second row R2 and a fourth row R4 and may be repeatedly disposed in the second direction Y in a second column C2 and a fourth column C4.

Each of the first through third emission areas EA1 through EA3 may be defined by a first opening OP1 and a second opening OP2 formed by an inorganic pixel defining layer 151 (see FIG. 7) and a bank structure 160 (see FIG. 7) which will be described later.

The non-emission area NLA may surround the emission areas EA1 through EA3. The non-emission area NLA may be an area from which no light is emitted. The inorganic pixel defining layer 151 and a light blocking pattern BM (see FIG. 7), which will be described later, may be located in the non-emission area NLA.

FIG. 7 is a cross-sectional view of the display device 10 taken along line X1-X1' of FIG. 6.

Referring to FIG. 7, the display panel 100 may include the substrate 110, the thin-film transistor layer 130, the light emitting element layer 150, the thin-film encapsulation layer 170, and the touch sensor layer 180.

Since the substrate 110 has already been mentioned, a description thereof will be omitted.

The thin-film transistor layer 130 may include a first buffer layer 111, bottom metal layers BML, a second buffer layer 113, thin-film transistors TFT, a gate insulating layer 131, a first interlayer-insulating layer 133, capacitor electrodes CPE, a second interlayer-insulating layer 135, first connection electrodes CNE1, a first passivation layer 137, second connection electrodes CNE2, and a second passivation layer 139.

The first buffer layer 111 may be disposed on the substrate 110. The first buffer layer 111 may include an inorganic layer that can prevent penetration of air or moisture. In an embodiment, for example, the first buffer layer 111 may include a plurality of inorganic layers stacked alternately.

The bottom metal layers BML may be disposed on the first buffer layer 111. In an embodiment, for example, each of the bottom metal layers BML may be a single layer or a multilayer made of any one or more of molybdenum (Mo), aluminium (Al), chromium (Cr), gold (Au), titanium (Ti), nickel (Ni), neodymium (Nd), copper (Cu), and alloys thereof.

The second buffer layer 113 may cover the first buffer layer 111 and the bottom metal layers BML. The second buffer layer 113 may include an inorganic layer that can prevent penetration of air or moisture. In an embodiment, for example, the second buffer layer 113 may include a plurality of inorganic layers stacked alternately.

The thin-film transistors TFT may be disposed on the second buffer layer 113. The thin-film transistors TFT may constitute respective pixel circuits of a plurality of pixels. In an embodiment, for example, each of the thin-film transistors TFT may be a driving transistor or a switching transistor of a pixel circuit. Each of the thin-film transistors TFT may include a semiconductor layer ACT, a source electrode SE, a drain electrode DE, and a gate electrode GE.

The semiconductor layer ACT may be disposed on the second buffer layer 113. The semiconductor layer ACT may overlap a bottom metal layer BML and the gate electrode GE in the third direction (Z-axis direction) and may be insulated from the gate electrode GE by the gate insulating layer 131. In portions of the semiconductor layer ACT, the material of the semiconductor layer ACT may be made conductive to form the source electrode SE and the drain electrode DE.

The gate electrode GE may be disposed on the gate insulating layer 131. The gate electrode GE may overlap the semiconductor layer ACT with the gate insulating layer 131 interposed between them in a plan view.

The gate insulating layer 131 may be disposed on the semiconductor layers ACT. In an embodiment, for example, the gate insulating layer 131 may cover the semiconductor layers ACT and the second buffer layer 113 and may insulate the semiconductor layers ACT from the gate electrodes GE. The gate insulating layer 131 may include contact holes through which the first connection electrodes CNE1 pass.

The first interlayer-insulating layer 133 may cover the gate electrodes GE and the gate insulating layer 131. The first interlayer-insulating layer 133 may include contact holes through which the first connection electrodes CNE1 pass. The contact holes of the first interlayer-insulating layer 133 may be connected to the contact holes of the gate insulating layer 131 and contact holes of the second interlayer-insulating layer 135.

The capacitor electrodes CPE may be disposed on the first interlayer-insulating layer 133. The capacitor electrodes CPE may overlap the gate electrodes GE in a thickness direction (Z-axis direction) of the substrate 110. The capacitor electrodes CPE and the gate electrodes GE may form capacitances.

The second interlayer-insulating layer 135 may cover the capacitor electrodes CPE and the first interlayer-insulating layer 133. The second interlayer-insulating layer 135 may include the contact holes through which the first connection electrodes CNE1 pass. The contact holes of the second interlayer-insulating layer 135 may be connected to the contact holes of the first interlayer-insulating layer 133 and the contact holes of the gate insulating layer 131.

The first connection electrodes CNE1 may be disposed on the second interlayer-insulating layer 135. The first connection electrodes CNE1 may electrically connect the drain electrodes DE of the thin-film transistors TFT to the second connection electrodes CNE2. The first connection electrodes CNE1 may be inserted into the contact holes defined in the second interlayer-insulating layer 135, the first interlayer-insulating layer 133 and the gate insulating layer 131 to contact the drain electrodes DE of the thin-film transistors TFT.

The first passivation layer 137 may cover the first connection electrodes CNE1 and the second interlayer-insulating layer 135. The first passivation layer 137 may protect the thin-film transistors TFT. The first passivation layer 137 may include contact holes through which the second connection electrodes CNE2 pass.

The second connection electrodes CNE2 may be disposed on the first passivation layer 137. The second connection electrodes CNE2 may electrically connect the first connection electrodes CNE1 to pixel electrodes AE1 through AE3 of light emitting elements ED1 through ED3. The second connection electrodes CNE2 may be inserted into the contact holes defined in the first passivation layer 137 to contact the first connection electrodes CNE1.

The second passivation layer 139 may cover the second connection electrodes CNE2 and the first passivation layer 137. The second passivation layer 139 may include contact holes through which the pixel electrodes AE1 through AE3 of the light emitting elements ED1 through ED3 pass.

The light emitting element layer 150 may be disposed on the thin-film transistor layer 130. The light emitting element layer 150 may include the light emitting elements ED1 through ED3, the inorganic pixel defining layer 151, the bank structure 160, and auxiliary electrodes AXE.

The light emitting elements ED1 through ED3 may be disposed on the second passivation layer 139. The light emitting elements ED1 through ED3 may include the pixel electrodes AE1 through AE3, light emitting layers EL1 through EL3, and common electrodes CE1 through CE3.

The pixel electrodes AE1 through AE3 may be disposed in the emission areas EA1 through EA3, respectively. The pixel electrodes AE1 through AE3 may include a first pixel electrode AE1 disposed in a first emission area EA1, a second pixel electrode AE2 disposed in a second emission area EA2, and a third pixel electrode AE3 disposed in a third emission area EA3. The pixel electrodes AE1 through AE3 may be spaced apart from each other on the second passivation layer 139. The pixel electrodes AE1 through AE3 may be disposed in different emission areas EA1 through EA3 to form the light emitting elements ED1 through ED3 for emitting light of different colors, respectively.

The pixel electrodes AE1 through AE3 may be electrically connected to the drain electrodes DE of the thin-film transistors TFT through the first and second connection electrodes CNE1 and CNE2. In an embodiment, the pixel electrodes AE1 through AE3 may have a stacked structure of a material layer having a high work function such as indium tin oxide ("ITO"), indium zinc oxide ("IZO"), zinc oxide (ZnO) or indium oxide (In₂O₃) and a reflective material layer such as silver (Ag), magnesium (Mg), aluminium (Al), platinum (Pt), lead (Pb), palladium (Pd), gold (Au), nickel (Ni), neodymium (Nd), iridium (Ir), chromium (Cr), lithium (Li), calcium (Ca) or a mixture thereof. The material layer having a high work function may be disposed on the reflective material layer so that it is located close to the light emitting layers EL1 through EL3. In an embodiment, for example, the pixel electrodes AE1 through AE3 may have, but are not limited to, a multilayer structure of ITO/Mg, ITO/MgF, ITO/Ag, or ITO/Ag/ITO.

The inorganic pixel defining layer 151 may be located on the second passivation layer 139 and the pixel electrodes AE1 through AE3. The inorganic pixel defining layer 151 may define a plurality of first openings OP1 therein overlapping the emission areas EA1 through EA3, respectively, in a plan view. The inorganic pixel defining layer 151 may be disposed on the entirety of the second passivation layer 139 to overlap the non-emission area NLA but may overlap the emission areas EA1 through EA3 to partially overlap the pixel electrodes AE1 through AE3. The inorganic pixel defining layer 151 may partially expose upper surfaces of the pixel electrodes AE1 through AE3 overlapping the first openings OP1 in a plan view.

The inorganic pixel defining layer 151 may include an inorganic insulating material. In an embodiment, for example, the inorganic pixel defining layer 151 may include aluminium oxide (Al₂O₃), titanium oxide (TiO₂), tantalum oxide (Ta₂O₅), hafnium oxide (HfO₂), zinc oxide (ZnO), silicon oxide (SiO₂), silicon nitride (Si₃N₄), or silicon oxycarbide (SiOC).

The bank structure 160 may be located in the non-emission area NLA and may be located on the inorganic pixel defining layer 151. The bank structure 160 may define a plurality of second openings OP2 that form the emission areas EA1 through EA3. The bank structure 160 may include a first bank layer 161 and a second bank layer 163 including different conductive materials and structures and playing different roles.

The first bank layer 161 may be located on the inorganic pixel defining layer 151. In the display device 10 according to the embodiment, the common electrodes CE1 through CE3 disposed in different emission areas EA1 through EA3 may not be directly connected to each other but may be electrically connected through the first bank layer 161 of the bank structure 160. Therefore, the common electrodes CE1 through CE3 disposed in different emission areas EA1 through EA3 may be spaced apart from each other with the bank structure 160 interposed between them. The common electrodes CE1 through CE3 disposed in different emission areas EA1 through EA3 may contact the bank structure 160. The first bank layer 161 may include a metal having high electrical conductivity. In an embodiment, for example, the first bank layer 161 may include aluminium (Al).

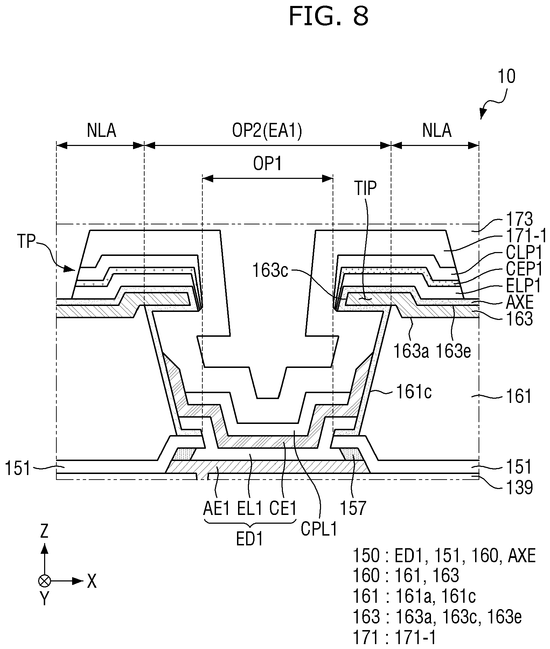

The second bank layer 163 may be located on the first bank layer 161. The second bank layer 163 may include a material having a lower etch rate than the material of the first bank layer 161. In an embodiment, for example, the second bank layer 163 may include titanium (Ti). The second bank layer 163 may include tips TIP protruding toward the first openings OP1 from side surfaces 161c (see FIG. 8) of the first bank layer 161. The protruding tips TIP of the second bank layer 163 may protrude more than the side surfaces 161c of the first bank layer 161 to toward emission areas in a direction parallel to the major surface of the substrate 110. Therefore, an undercut may be formed between each protruding tip portion TIP of the second bank layer 163 and a side surfaces 161c of the first bank layer 161. Here, the major surface (e.g., upper surface) of the substrate 100 may be parallel to a plane defined by the first direction (X-axis direction) and the second direction (Y-axis direction).

In some embodiments, the auxiliary electrodes AXE may be located on the inorganic pixel defining layer 151 and the bank structure 160. The auxiliary electrodes AXE may cover portions of the inorganic pixel defining layer 151 and the whole of the bank structure 160, but may not overlap the first openings OP1 to expose the light emitting elements ED1 through ED3 in a plan view. In other words, a plurality of auxiliary electrodes AXE may be spaced apart from each other with the first openings OP1 interposed between them and may overlap the non-emission area NLA. Specifically, the auxiliary electrodes AXE may overlap the second openings OP2 to cover the inorganic pixel defining layer 151 and the bank structure 160 in a plan view and may overlap the non-emission area NLA to cover the second bank layer 163.

The auxiliary electrodes AXE may help the common electrodes CE1 through CE3 to be electrically connected to the bank structure 160. As mentioned above, in the display device 10, the common electrodes CE1 through CE3 disposed in different emission areas EA1 through EA3 are not directly connected to each other but may be electrically connected through the first bank layer 161 of the bank structure 160. Therefore, as a contact area between the common electrodes CE1 through CE3 and the first bank layer 161 increases, the driving resistance of the display device 10 may be reduced, and the display device 10 may be electrically stable. In the display device 10 included in the current embodiment, the auxiliary electrodes AXE located between the common electrodes CE1 through CE3 and the first bank layer 161 may help the common electrodes CE1 through CE3 to be easily electrically connected to the first bank layer 161.

The auxiliary electrodes AXE may include a conductive metal. In the current embodiment, a case where each of the auxiliary electrodes AXE is indium-tin-oxide (ITO) will be described later as an example, but the present disclosure is not limited to this case. The auxiliary electrode AXE may also include any metal oxide including a conductive material, such as indium-zinc-oxide (IZO), zinc oxide (ZnO), indium-gallium-zinc-oxide (IGZO), or indium-zinc-tin oxide.

In some embodiments, a high-temperature heat treatment process may be included in a process of fabricating the auxiliary electrodes AXE. The auxiliary electrodes AXE may include a crystallized transparent oxide. In an embodiment, for example, the auxiliary electrodes AXE may include polymerized indium-tin-oxide (ITO). The auxiliary electrodes AXE may secure improved conductivity and stability through the high-temperature heat treatment process. Therefore, the display device 10 including the auxiliary electrodes AXE between the common electrodes CE1 through CE3 and the first bank layer 161 can reduce its driving resistance and have electrical stability.

The light emitting layers EL1 through EL3 may be disposed on the pixel electrodes AE1 through AE3. The light emitting layers EL1 through EL3 may be organic light emitting layers made of an organic material and may be formed on the pixel electrodes AE1 through AE3 through a deposition process. When the thin-film transistors TFT apply a predetermined voltage to the pixel electrodes AE1 through AE3 and when the common electrodes CE1 through CE3 receive a common voltage or a cathode voltage, holes and electrons may move to the light emitting layers EL1 through EL3 through hole transporting layers and electron transporting layers, respectively. Then, the holes and the electrons may be combined with each other in the light emitting layers EL1 through EL3 to emit light.

The light emitting layers EL1 through EL3 may include a first light emitting layer EL1, a second light emitting layer EL2, and a third light emitting layer EL3 disposed in different emission areas EA1 through EA3. The first light emitting layer EL1 may be disposed on the first pixel electrode AE1 in the first emission area EA1, the second light emitting layer EL2 may be disposed on the second pixel electrode AE2 in the second emission area EA2, and the third light emitting layer EL3 may be disposed on the third pixel electrode AE3 in the third emission area EA3. In an embodiment, for example, the first light emitting layer EL1 may be a light emitting layer that emits light of a first color, i.e., red light, the second light emitting layer EL2 may be a light emitting layer that emits light of a second color, i.e., green light, and the third light emitting layer EL3 may be a light emitting layer that emits light of a third color, i.e., blue light.

The common electrodes CE1 through CE3 may be disposed on the light emitting layers EL1 through EL3. The common electrodes CE1 through CE3 may include a transparent conductive material to allow light generated by the light emitting layers EL1 through EL3 to pass therethrough. The common electrodes CE1 through CE3 may receive a common voltage or a low potential voltage. When the pixel electrodes AE1 through AE3 receive voltages corresponding to data voltages and the common electrodes CE1 through CE3 receive a low potential voltage, a potential difference may be formed between the pixel electrodes AE1 through AE3 and the common electrode CE1 through CE3. Accordingly, the light emitting layers EL1 through ED3 may emit light.

In an embodiment, for example, the common electrodes CE1 through CE3 may include silver (Ag). However, the present disclosure is not limited thereto. The common electrodes CE1 through CE3 may include a material layer having a small work function such as Li, Ca, LiF/Ca, LiF/Al, Al, Mg, Pt, Pd, Ni, Au Nd, Ir, Cr, BaF, Ba, or a compound or mixture thereof (e.g., a mixture of Ag and Mg) in another embodiment. The common electrodes CE1 through CE3 may further include a transparent metal oxide layer disposed on the material layer having a small work function.

In the display device 10, the common electrodes CE1 through CE3 can be individually disposed in different areas by the tips TIP of the bank structure 160 even in a deposition process not using a mask. The common electrodes CE1 through CE3 may include a first common electrode CE1, a second common electrode CE2, and a third common electrode CE3 disposed in different emission areas EA1 through EA3. The first common electrode CE1 may be disposed on the first light emitting layer EL1 in the first emission area EA1, the second common electrode CE2 may be disposed on the second light emitting layer EL2 in the second emission area EA2, and the third common electrode CE3 may be disposed on the third light emitting layer EL3 in the third emission area EA3. The common electrodes CE1 through CE3 formed individually may be electrically connected to each other by the auxiliary electrodes AXE and the first bank layer 161.

A portion of each of the common electrodes CE1 through CE3 may contact an auxiliary electrode AXE. As mentioned above, the auxiliary electrodes AXE may help the first bank layer 161 and the common electrodes CE1 through CE3 to be electrically connected to each other. As the contact area between the common electrodes CE1 through CE3 and the auxiliary electrodes AXE increases, the driving resistance of the display device 10 may decrease.

Capping layers CPL1 through CPL3 may be disposed on the common electrodes CE1 through CE3. The capping layers CPL1 through CPL3 may include an inorganic insulating material to cover the light emitting elements ED1 through ED3. The capping layers CPL1 through CPL3 may prevent the light emitting elements ED1 through ED3 from being damaged by external air. The capping layers CPL1 through CPL3 may include a first capping layer CPL1 overlapping the first emission area EA1, a second capping layer CPL2 overlapping the second emission area EA2, and a third capping layer CPL3 overlapping the third emission area EA3.

The capping layers CPL1 through CPL3 overlapping the emission areas EA1 through EA3, respectively, may overlap the first openings OP1 to completely cover the common electrodes CE1 through CE3. However, the capping layers CPL1 through CPL3 overlapping the emission areas EA1 through EA3, respectively, may overlap the second openings OP2 to partially expose the common electrodes CE1 through CE3 in a plan view. The capping layers CPL1 through CPL3 may protect the common electrodes CE1 through CE3 to prevent them from peeling off.

The capping layers CPL1 through CPL3 may include aluminium oxide (Al₂O₃), titanium oxide (TiO₂), tantalum oxide (Ta₂O₅), hafnium oxide (HfO₂), zinc oxide (ZnO), silicon oxide (SiO₂), silicon nitride (Si₃N₄), or silicon oxycarbide (SiOC).

Referring to FIG. 7, a plurality of organic patterns ELP1 through ELP3, a plurality of electrode patterns CEP1 through CEP3, and a plurality of capping patterns CLP1 through CLP3 may be disposed on the auxiliary electrodes AXE to surround the first openings OP1. The organic patterns ELP1 through ELP3, the electrode patterns CEP1 through CEP3, and the capping patterns CLP1 through CLP3 may be partially etched during a process of fabricating the display device 10. Accordingly, the organic patterns ELP1 through ELP3, the electrode patterns CEP1 through CEP3, and the capping patterns CLP1 through CLP3 may define trenches TP overlapping the non-emission area NLA (See FIG. 8).

The organic patterns ELP1 through ELP3 may be located on the auxiliary electrodes AXE. The organic patterns ELP1 through ELP3 may include the same materials as the light emitting layers EL1 through EL3, respectively. A first organic pattern ELP1 may include the same material as the first light emitting layer EL1 of a first light emitting element ED 1, a second organic pattern ELP2 may include the same material as the second light emitting layer EL2 of a second light emitting element ED2, and a third organic pattern ELP3 may include the same material as the third light emitting layer EL3 of a third light emitting element ED3. The organic patterns ELP1 through ELP3 may be traces formed by being separated from the light emitting layers EL1 through EL3 because the bank structure 160 includes the tips TIP.

The electrode patterns CEP1 through CEP3 may be disposed on the organic patterns ELP1 through ELP3, respectively. In an embodiment, for example, a first electrode pattern CEP1, a second electrode pattern CEP2, and a third electrode pattern CEP3 may be directly disposed on the first organic pattern ELP1, the second organic pattern ELP2, and the third organic pattern ELP3, respectively. The arrangement relationship between the electrode patterns CEP1 through CEP3 and the organic patterns ELP1 through ELP3 may be the same as the arrangement relationship between the light emitting layers EL1 through EL3 and the common electrodes CE1 through CE3. The electrode patterns CEP1 through CEP3 may include the same materials as the common electrodes CE1 through CE3, respectively. The electrode patterns CEP1 through CEP3 may be traces formed when deposited materials are separated from the common electrodes CE1 through CE3 because the bank structure 160 includes the tips TIP.

The capping patterns CLP1 through CLP3 may be located on the electrode patterns CEP1 through CEP3. The capping patterns CLP1 through CLP3 may include the same material as the capping layers CPL1 through CPL3. The arrangement relationship between the capping patterns CLP1 through CLP3 and the electrode patterns CEP1 through CEP3 may be the same as the arrangement relationship between the capping layers CPL1 through CPL3 and the common electrodes CE1 through CE3. The capping patterns CLP1 through CLP3 may be traces formed when the capping layers CPL1 through CPL3 are broken by the tips TIP included in the bank structure 160. The capping patterns CLP1 through CLP3 may prevent peeling of patterns thereunder during a fabrication process.

The thin-film encapsulation layer 170 may be disposed on the light emitting elements ED1 through ED3, the auxiliary electrodes AXE and the capping patterns CLP1 through CLP3 and may cover the light emitting elements ED1 through ED3, the auxiliary electrodes AXE and the capping patterns CLP1 through CLP3. The thin-film encapsulation layer 170 may include at least one inorganic layer to prevent oxygen or moisture from penetrating into the light emitting element layer 150. The thin-film encapsulation layer 170 may include at least one organic layer to protect the light emitting element layer 150 from foreign substances such as dust. In an embodiment, the thin-film encapsulation layer 170 may include a first encapsulation layer 171, a second encapsulation layer 173, and a third encapsulation layer 175 stacked sequentially. The first encapsulation layer 171 and the third encapsulation layer 175 may be inorganic encapsulation layers, and the second encapsulation layer 173 disposed between them may be an organic encapsulation layer.

Each of the first encapsulation layer 171 and the third encapsulation layer 175 may include one or more inorganic insulating materials. The inorganic insulating materials may include aluminium oxide, titanium oxide, tantalum oxide, hafnium oxide, zinc oxide, silicon oxide, silicon nitride, and silicon oxynitride.

The second encapsulation layer 173 may include a polymer-based material. Examples of the polymer-based material may include acrylic resin, epoxy resin, polyimide, and polyethylene. In an embodiment, for example, the second encapsulation layer 173 may include acrylic resin such as polymethyl methacrylate or polyacrylic acid. The second encapsulation layer 173 may be formed by curing a monomer or applying a polymer.

The first encapsulation layer 171 may include first through third inorganic layers 171-1 through 171-3 disposed to correspond to different emission areas EA1 through EA3, respectively.

The first through third inorganic layers 171-1 through 171-3 may cover the light emitting elements ED1 through ED3, the auxiliary electrodes AXE, and the capping patterns CLP1 through CLP3. Since the first through third inorganic layers 171-1 through 171-3 can be formed through chemical vapor deposition (CVD), they can be formed to a uniform thickness along steps of layers on which they are deposited. In an embodiment, for example, each of the first through third inorganic layers 171-1 through 171-3 may form a thin layer even under an undercut formed by a tip TIP of the bank structure 160.

Although the first through third inorganic layers 171-1 through 171-3 are disposed on the same layer in FIG. 7, they may also be formed in different processes. In an embodiment, for example, the first inorganic layer 171-1 may be formed after the first common electrode CE1 is formed, the second inorganic layer 171-2 may be formed after the second common electrode CE2 is formed, and the third inorganic layer 171-3 may be formed after the third common electrode CE3 is formed.

The first through third inorganic layers 171-1 through 171-3 may overlap the non-emission area NLA but may be spaced apart from each other. Accordingly, the auxiliary electrodes AXE may be partially exposed. A portion of an upper surface of each of the exposed auxiliary electrodes AXE may contact the second encapsulation layer 173.

The touch sensor layer 180 may be disposed on the thin-film encapsulation layer 170. The touch sensor layer 180 may include a touch buffer layer 181, a touch insulating layer 183, touch electrodes TE, and a touch protection layer 185.

The touch buffer layer 181 may be disposed on the thin-film encapsulation layer 170. The touch buffer layer 181 may have insulating and optical functions. The touch buffer layer 181 may include at least one inorganic layer. Optionally, the touch buffer layer 181 may be omitted. Although not illustrated in the drawings, a connection electrode electrically connecting the touch electrodes may be disposed on the touch buffer layer 181. The connection electrode may be a single layer of molybdenum (Mo), titanium (Ti), copper (Cu), aluminium (Al) or indium tin oxide (ITO) or may be a stacked structure (Ti/Al/Ti) of aluminium and titanium, a stacked structure (ITO/A1/ITO) of aluminium and indium tin oxide, an APC alloy, or a stacked structure (ITO/APC/ITO) of an APC alloy and indium tin oxide.

The touch insulating layer 183 may cover the touch buffer layer 181. The touch insulating layer 183 may have an insulating function. In an embodiment, for example, the touch insulating layer 183 may be an inorganic layer including at least one of a silicon nitride layer, a silicon oxynitride layer, a silicon oxide layer, a titanium oxide layer, and an aluminium oxide layer.

The touch electrodes TE may be disposed on the touch insulating layer 183 to overlap the non-emission area NLA. Each of the touch electrodes TE may not overlap the first through third emission areas EA1 through EA3. Each of the touch electrodes TE may be a single layer of molybdenum (Mo), titanium (Ti), copper (Cu), aluminium (Al) or indium tin oxide (ITO) or may be a stacked structure (Ti/Al/Ti) of aluminium and titanium, a stacked structure (ITO/Al/ITO) of aluminium and indium tin oxide, an APC alloy, or a stacked structure (ITO/APC/ITO) of an APC alloy and indium tin oxide.

The touch protection layer 185 may cover the touch electrodes TE and the touch insulating layer 183. The touch protection layer 185 may have insulating and optical functions. The touch protection layer 185 may be made of at least one of the example materials of the touch insulating layer 183.

The light blocking layer BM may be located in the non-emission area NLA and disposed on the touch sensor layer 180. The light blocking layer BM may overlap the inorganic pixel defining layer 151, the bank structure 160, and the touch electrodes TE in a plan view. The light blocking layer BM may include a light absorbing material. In an embodiment, for example, the light blocking layer BM may include an inorganic black pigment or an organic black pigment. The inorganic black pigment may be carbon black, and the organic black pigment may include at least one of lactam black, perylene black, and aniline black. However, the present disclosure is not limited thereto. The light blocking layer BM may prevent color mixing by preventing intrusion of visible light between the first through third emission areas EA1 through EA3, thereby improving a color gamut of the display device 10.

The color filter layer 190 may be disposed on the touch protection layer 185 and the light blocking layer BM to overlap the emission areas EA1 through EA3.

The color filter layer 190 may include a first color filter 191, a second color filter 193, and a third color filter 195 disposed to correspond to different emission areas EA1 through EA3, respectively. Each of the color filters 191, 193 and 195 may include a colorant such as a dye or pigment that absorbs light in wavelength bands other than light in a specific wavelength band and may be disposed to correspond to the color of light emitted from one of the emission areas EA1 through EA3. In an embodiment, for example, the first color filter 191 may be a red color filter that overlaps the first emission area EA1 and transmits only red first light. The second color filter 193 may be a green color filter that overlaps the second emission area EA2 and transmits only green second light, and the third color filter 195 may be a blue color filter that overlaps the third emission area EA3 and transmits only blue third light.

In FIG. 7, each of the color filters 191, 193 and 195 is spaced apart from other adjacent color filters 191, 193 and 195 on the light blocking layer BM. However, the present disclosure is not limited thereto. In other words, each of the color filters 191, 193 and 195 may also partially overlap other adjacent color filters 191, 193 and 195. That is, different color filters 191, 193 and 195 may overlap the non-emission area NLA and may overlap each other on the light blocking layer BM.

An overcoat layer OC may be disposed on the color filter layer 190 and the light blocking layer BM to planarize upper ends of the color filters 191, 193 and 195. The overcoat layer OC may be a colorless light-transmitting layer that does not have a color in a visible light band. In an embodiment, for example, the overcoat layer OC may include a colorless light-transmitting organic material such as acrylic resin.

FIG. 8 is an enlarged cross-sectional view of the first emission area EA1 of FIG. 7.

Referring to FIG. 8, the inorganic pixel defining layer 151 may be located on the second passivation layer 139 and the first pixel electrode AE1. The inorganic pixel defining layer 151 may overlap a second opening OP2 and may be spaced apart from the first pixel electrode AE1 in the third direction (Z-axis direction) with a space between them. The space between the inorganic pixel defining layer 151 and the first pixel electrode AE1 may be formed by a sacrificial layer which will be described later.

The display device 10 may include a sacrificial layer between the inorganic pixel defining layer 151 and the first pixel electrode AE1 during a fabrication process. The sacrificial layer may be disposed between the inorganic pixel defining layer 151 and the first pixel electrode AE1 and then may be removed by a subsequent etching process. An unremoved portion of the sacrificial layer may remain as a residual pattern 157 between the inorganic pixel defining layer 151 and the first pixel electrode AE1. This will be described in detail later in the fabrication process.

In some embodiments, the first light emitting layer EL1 may be disposed in a portion between the inorganic pixel defining layer 151 and the first pixel electrode AE1. In a process of fabricating the first light emitting layer EL1 included in the current embodiment, the material of the first light emitting layer EL1 may be deposited at an angle in a direction between the first direction (X-axis direction) and the third direction (Z-axis direction). Accordingly, the first light emitting layer EL1 may be deposited while partially filling the portion between the first pixel electrode AE1 and the inorganic pixel defining layer 151. Therefore, the residual pattern 157 and the first light emitting layer EL1 may be located in contact with each other in the portion between the first pixel electrode AE1 and the inorganic pixel defining layer 151.

The bank structure 160 may be located on the inorganic pixel defining layer 151. The bank structure 160 may include the first bank layer 161 and the second bank layer 163 including different conductive materials.

The first bank layer 161 may include the side surfaces 161c facing a first opening OP1. The side surfaces 161c of the first bank layer 161 may be located in a diagonal shape in the direction between the first direction (X-axis direction) and the third direction (Z-axis direction). The side surfaces 161c of the first bank layer 161 may be recessed toward one side in the first direction (X-axis direction) more than side surfaces of the inorganic pixel defining layer 151. Therefore, the side surfaces 161c of the first bank layer 161 may overlap the second opening OP2 to partially expose the inorganic pixel defining layer 151.

The second bank layer 163 may be located on the first bank layer 161. The second bank layer 163 may include an upper surface 163e, a lower surface 163a, and side surfaces 163c.

The lower surface 163a of the second bank layer 163 may be a surface in contact with the first bank layer 161. The first bank layer 161 and the second bank layer 163 may cover along a step of the inorganic pixel defining layer 151. Accordingly, the lower surface 163a of the second bank layer 163 may include a step.

The side surfaces 163c of the second bank layer 163 may protrude toward the first opening OP1 from the side surfaces 161c of the first bank layer 161. Specifically, the first bank layer 161 and the second bank layer 163 may be formed through a wet etching process during the fabrication process. The second bank layer 163 may include a material that is relatively stable in the wet etching process compared with the material of the first bank layer 161. Therefore, the side surfaces 163c of the second bank layer 163 may protrude toward the first opening OP1 more than the side surfaces 161c of the first bank layer 161. In other words, the side surfaces 161c of the first bank layer 161 may be recessed toward one side in the first direction (X-axis direction) more than the side surfaces 163c of the second bank layer 163.

As illustrated in FIG. 8, the side surfaces 163c of the second bank layer 163 of the bank structure 160 may include tips TIP protruding toward the first opening OP1 more than the side surfaces 161c of the first bank layer 161. Accordingly, an undercut may be formed between the bottom of each tip TIP of the second bank layer 163 and a side surface 161c of the first bank layer 161.

The upper surface 163e of the second bank layer 163 may be a surface facing the lower surface 163a of the second bank layer 163. Like the lower surface 163a of the second bank layer 163, the upper surface 163e of the second bank layer 163 may cover along a step of the inorganic pixel defining layer 151.

An auxiliary electrode AXE may be located on the inorganic pixel defining layer 151 and the bank structure 160. The auxiliary electrode AXE may contact an upper surface of the inorganic pixel defining layer 151 exposed by the side surfaces 161c of the first bank layer 161. In addition, the auxiliary electrode AXE may contact the side surfaces 161c of the first bank layer 161 and the lower surface 163 a, side surfaces 163c and upper surface 163e of the second bank layer 163.

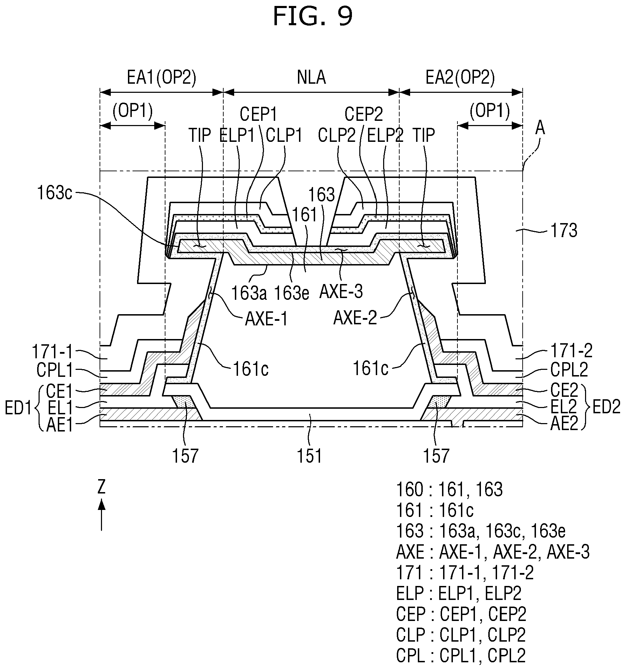

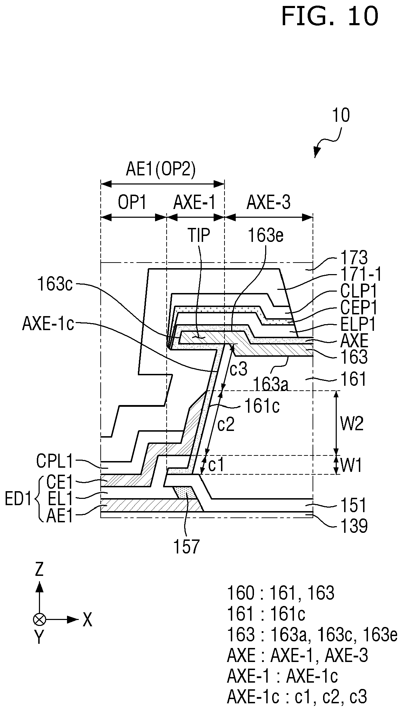

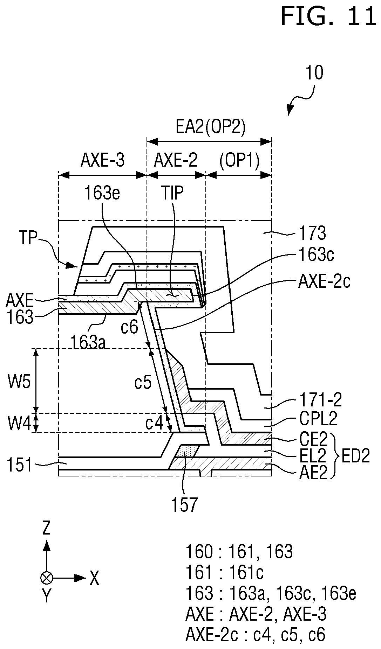

FIG. 9 is an enlarged cross-sectional view of area 'A' of FIG. 7. FIG. 10 is an enlarged cross-sectional view of a first portion AXE-1 of an auxiliary electrode AXE of FIG. 9. FIG. 11 is an enlarged cross-sectional view of a second portion AXE-2 of the auxiliary electrode AXE of FIG. 9.

Referring to FIG. 9, the auxiliary electrode AXE may completely cover the bank structure 160. In other words, the bank structure 160 may be completely surrounded by the inorganic pixel defining layer 151 and the auxiliary electrode AXE.

In some embodiments, the auxiliary electrode AXE may include the first portion AXE-1 overlapping the first emission area EA1, the second portion AXE-2 overlapping the second emission area EA2, and a third portion AXE-3 overlapping the non-emission area NLA. The first portion AXE-1 overlapping the first emission area EA1 and the second portion AXE-2 overlapping the second emission area EA2 may be extended from the third portion AXE-3 overlapping the non-emission area NLA.

In some embodiments, the first portion AXE-1 of the auxiliary electrode AXE may contact the upper surface of the inorganic pixel defining layer 151 and may cover the upper surface of the inorganic pixel defining layer 151. The first portion AXE-1 of the auxiliary electrode AXE may overlap the inorganic pixel defining layer 151 and the first light emitting layer EL1 in the third direction (Z-axis direction). In addition, the first portion AXE-1 of the auxiliary electrode AXE may overlap a second opening OP2, may be located on a side surface 161c of the first bank layer 161 to contact the side surface 161c of the first bank layer 161, and may completely cover the side surface 161c of the first bank layer 161. In addition, the first portion AXE-1 of the auxiliary electrode AXE may contact a protruding tip TIP of the second bank layer 163 and may completely cover the protruding tip TIP of the second bank layer 163. Specifically, the first portion AXE-1 of the auxiliary electrode AXE may contact the lower surface 163a, side surface 163c and upper surface 163e of the second bank layer 163 to completely cover the protruding tip TIP of the second bank layer 163. The first portion AXE-1 of the auxiliary electrode AXE may overlap the first emission area EA1 to cover the bank structure 160, thereby protecting the side surface 161c of the first bank layer 161 and the protruding tip TIP of the second bank layer 163 from repeated etching processes.

Referring to FIG. 10, the first portion AXE-1 of the auxiliary electrode AXE may include a side surface AXE-1c located on the side surface 161c of the first bank layer 161. The side surface AXE-1c of the first portion AXE-1 may overlap the first emission area EA1 and the protruding tip TIP of the second bank layer 163.

The first light emitting layer EL1, the first common electrode CE1, and the first inorganic layer 171-1 may partially contact the side surface AXE-1c of the first portion AXE-1. Therefore, the side surface AXE-1c of the first portion AXE-1 may be divided into a first sub-portion c1 in contact with the first light emitting layer EL1, a second sub-portion c2 in contact with the first common electrode CE1, and a third sub-portion c3 in contact with the first inorganic layer 171-1. A width W1 of the first sub-portion c1 in contact with the first light emitting layer EL1 may be smaller than a width W2 of the second sub-portion c2 in contact with the first common electrode CE1. This is because a deposition process for forming the common electrodes CE1 through CE3 is performed at an angle more inclined to a major surface of the substrate 110 than the angle of a deposition process for forming the light emitting layers EL1 through EL3 during a process of fabricating the light emitting elements ED1 through ED3.

In an embodiment, when the angle of the deposition process for forming the light emitting layers EL1 through EL3 is defined as a first angle, the deposition process for forming the light emitting layers EL1 through EL3 may be performed at an angle of 45 to 50 degrees with respect to the upper surfaces of the pixel electrodes AE1 through AE3. That is, the first angle may be 45 to 50 degrees. Therefore, the light emitting layers EL1 through EL3 may be formed to fill the spaces between the pixel electrodes AE1 through AE3 and the inorganic pixel defining layer 151 and may also be disposed on sidewalls of the second openings OP2 in areas covered by the protruding tips TIP of the bank structure 160.

In addition, when the angle of the deposition process for forming the common electrodes CE1 through CE3 is defined as a second angle, the deposition process for forming the common electrodes CE1 through CE3 may be performed at an angle of 30 degrees or less with respect to the upper surfaces of the pixel electrodes AE1 through AE3. Therefore, in the surface AXE-1c of the first portion AXE-1, the width W 1 of the first sub-portion c1 in contact with the first light emitting layer EL1 may be smaller than the second width W2 of the second sub-portion c2 in contact with the first common electrode CE1. The 'width' may be measured in the third direction (Z-axis direction) or the surface direction of the side surface AXE-1c as shown in FIG. 10.

As described above, as the width W2 by which the first common electrode CE1 contacts the auxiliary electrode AXE increases, the total area in which the first common electrode CE1 contacts the auxiliary electrode AXE per each emission area increases and the driving resistance of the display device 10 may decrease. Therefore, the electrical characteristics of the display device 10 may be effectively stabilized.

Referring to FIG. 9, the second portion AXE-2 of the auxiliary electrode AXE may contact the inorganic pixel defining layer 151 overlapping the second pixel electrode AE2 in a plan view and may cover the upper surface of the inorganic pixel defining layer 151. In addition, the second portion AXE-2 of the auxiliary electrode AXE may be located on a side surface 161c of the first bank layer 161 to contact the side surface 161c of the first bank layer 161 and may completely cover the side surface 161c of the first bank layer 161. In addition, the second portion AXE-2 of the auxiliary electrode AXE may overlap a protruding tip TIP of the second bank layer 163 and may completely cover the protruding tip TIP of the second bank layer 163. Specifically, the second portion AXE-2 of the auxiliary electrode AXE may contact the lower surface 163a, side surface 163c and upper surface 163e of the second bank layer 163 to completely cover the protruding tip TIP of the second bank layer 163. The second portion AXE-2 of the auxiliary electrode AXE may overlap the second emission area EA2 to cover the bank structure 160, thereby protecting the side surface 161c of the first bank layer 161 and the protruding tip TIP of the second bank layer 163 from repeated etching processes.

Referring to FIG. 11, the second portion AXE-2 of the auxiliary electrode AXE may include a side surface AXE-2c located on the side surface 161c of the first bank layer 161. The side surface AXE-2c of the second portion AXE-2 may overlap the second emission area EA2 and the protruding tip TIP of the bank structure 160.

The second light emitting layer EL2, the second common electrode CE2, and the second inorganic layer 171-2 may contact the side surface AXE-2c of the second portion AXE-2. Therefore, the side surface AXE-2c of the second portion AXE-2 may be divided into a first sub-portion c4 in contact with the second light emitting layer EL2, a second sub-portion c5 in contact with the second common electrode CE2, and a third sub-portion c6 in contact with the second inorganic layer 171-2. A width W4 of the first sub-portion c4 in contact with the second light emitting layer EL2 may be smaller than a width W5 of the second sub-portion c5 in contact with the second common electrode CE2. Since other details have already been mentioned, a description thereof will be omitted.

Referring to FIG. 9, the third portion AXE-3 of the auxiliary electrode AXE may overlap the non-emission area NLA and may extend to the first portion AXE-1 and the second portion AXE-2 of the auxiliary electrode AXE. That is, the first portion AXE-1, the second portion AXE-2, and the third portion AXE-3 of the auxiliary electrode AXE may extend as a single portion. The third portion AXE-3 of the auxiliary electrode AXE may contact the upper surface 163e of the second bank layer 163 and may cover the upper surface 163e of the second bank layer 163.

The organic patterns ELP1 and ELP2, the electrode patterns CEP1 and CEP2, the capping patterns CLP1 and CLP2, and the first encapsulation layer 171-1 and 171-2 may be located on the auxiliary electrode AXE to overlap the third portion AXE-3 of the auxiliary electrode AXE in a plan view.

The first organic pattern ELP1, the first electrode pattern CEP1 and the first capping pattern CLP1 overlapping the third portion AXE-3 of the auxiliary electrode AXE may be separated from the second organic pattern ELP2, the second electrode pattern CEP2 and the second capping pattern CLP2 overlapping the third portion AXE-3 of the auxiliary electrode AXE in a plan view. In addition, the first inorganic layer 171-1 and the second inorganic layer 171-2 overlapping the third portion AXE-3 of the auxiliary electrode AXE may be spaced apart from each other in a plan view. This may result from an etching process included in the fabrication process of the display device 10. Specifically, the first organic pattern ELP1, the first electrode pattern CEP1, the first capping pattern CLP1, and the first inorganic layer 171-1 may be deposited not only in the first emission area EA1 but also in the second emission area EA2 and the third emission area EA3 during the fabrication process and then may be formed in the shape of the illustrated patterns by a subsequent etching process. In addition, the second organic pattern ELP2, the second electrode pattern CEP2, the second capping pattern CLP2, and the second inorganic layer 171-2 may be deposited not only in the second emission area EA2 but also in the first emission area EA1 and the third emission area EA3 during the fabrication process and then may be formed in the shape of the illustrated patterns by a subsequent etching process. Therefore, the third portion AXE-3 of the auxiliary electrode AXE may be partially exposed by a plurality of patterns and the first encapsulation layer 171-1 and 171-2 spaced apart from each other. The third portion AXE-3 of the auxiliary electrode AXE may protect the second bank layer 163 from repeated etching processes.

The second encapsulation layer 173 may be located on the first inorganic layer 171-1 and the second inorganic layer 171-2. The third portion AXE-3 of the auxiliary electrode AXE partially exposed by the patterns and the first encapsulation layer 171-1 and 171-2 spaced apart from each other may contact the second encapsulation layer 173. For ease of description, the structure overlapping the first emission area EA1 and the second emission area EA2 has been illustrated and described. However, structures included in the emission areas EA1 through EA3 and the non-emission area NLA located in the display area DA of the display device 10 may include the same features as the above-described structure.

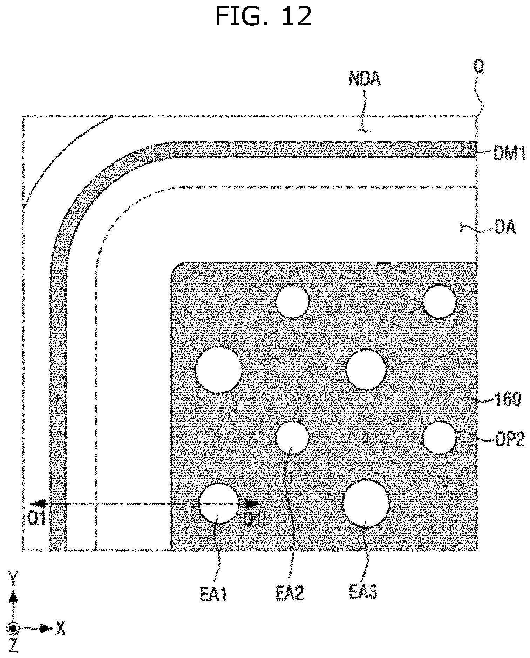

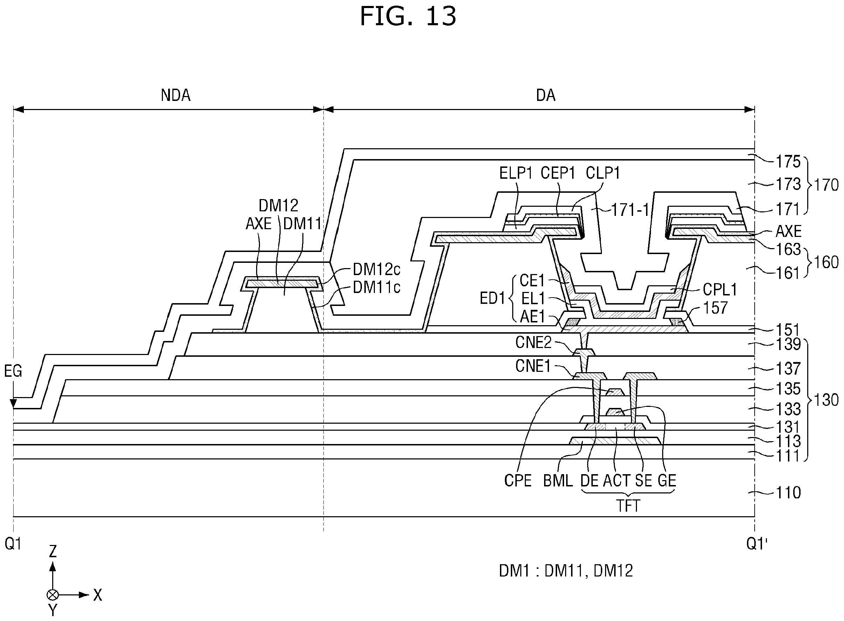

FIG. 12 is an enlarged plan view of area 'Q' of FIG. 2. FIG. 13 is a cross-sectional view of an example of the display device 10 taken along line Q1-Q1' of FIG. 12.

Referring to FIG. 12, the emission areas EA1 through EA3 may be located in the display area DA, and the bank structure 160 may surround the emission areas EA1 through EA3. The emission areas EA1 through EA3 may be formed by the second openings OP2 defined by the bank structure 160.

Referring to FIGS. 12 and 13, a dam structure DM1 surrounding the display area DA may be located in the non-display area NDA. The dam structure DM1 may be located between an end EG of the substrate 110 and the bank structure 160 of the display area DA. The dam structure DM1 may be formed to prevent an organic material applied to the display area DA from overflowing into the non-display area NDA. In an embodiment, for example, the second encapsulation layer 173 applied to the display area DA may not flow to the non-display area NDA due to the dam structure DM1.

The dam structure DM1 may be located on the second passivation layer 139 to overlap the non-display area NDA. The dam structure DM1 may include a first dam layer DM11 and a second dam layer DM12. The first dam layer DM11 may include the same material as the first bank layer 161 of the bank structure 160, and the second dam layer DM12 may include the same material as the second bank layer 163 of the bank structure 160. The dam structure DM1 may be formed to extend from the bank structure 160 during the fabrication process and then may be formed in the shape of the illustrated dam structure DM1 by a subsequent etching process. That is, the dam structure DM1 may be integrally formed with the bank structure 160 during the fabrication process and then may be separated from the bank structure 160 by a subsequent process.

Side surfaces DM12c of the second dam layer DM12 may protrude more than side surfaces DM11c of the first dam layer DM11 in the first direction (X-axis direction). Therefore, undercuts may be formed between the second dam layer DM12 and the first dam layer DM11. The first dam layer DM11 and the second dam layer DM12 may have the same shape as the first bank layer 161 and the second bank layer 163.

An auxiliary electrode AXE may be located on the dam structure DM1. The auxiliary electrode AXE may extend from the display area DA to the non-display area NDA. The auxiliary electrode AXE may completely cover the dam structure DM1 in the non-display area NDA. The auxiliary electrode AXE may also cover the undercut portions between the first dam layer DM11 and the second dam layer DM12 included in the dam structure DM1. Specifically, the auxiliary electrode AXE may be located on opposite side surfaces DM11c of the first dam layer DM11 to contact them and may completely cover opposite side surfaces DM11c of the first dam layer DM11. In addition, the auxiliary electrode AXE may contact opposite protruding portions of the second dam layer DM12 and completely cover opposite protruding portions of the second dam layer DM12. In addition, the auxiliary electrode AXE may contact an upper surface of the second dam layer DM12 and completely cover the upper surface of the second dam layer DM12. The auxiliary electrode AXE covering the first dam layer DM11 and the second dam layer DM12 may extend as a single electrode.

The first encapsulation layer 171 may be located on the auxiliary electrode AXE to overlap the dam structure DM1 located in the non-display area NDA. The first encapsulation layer 171 may extend along the auxiliary electrode AXE to cover the auxiliary electrode AXE. The first encapsulation layer 171 may extend to the end EG of the substrate 110 to prevent penetration of moisture and oxygen from the non-display area NDA into the display area DA.

The third encapsulation layer 175 may be located on the first encapsulation layer 171 to overlap the dam structure DM1 located in the non-display area NDA. Since the second encapsulation layer 173 does not flow to the non-display area NDA due to the dam structure DM1 as described above, the second encapsulation layer 173 may not overlap an upper surface of the dam structure DM1 in a plan view. Therefore, the first encapsulation layer 171 and the third encapsulation layer 175 overlapping the non-display area NDA may contact each other. The third encapsulation layer 175 may extend to the end EG of the substrate 110 to prevent penetration of moisture and oxygen from the non-display area NDA into the display area DA.

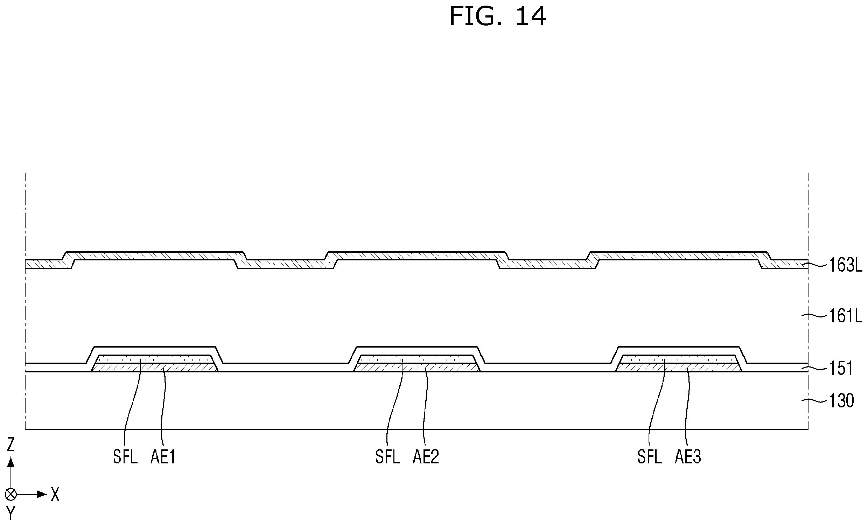

FIGS. 14 through 24 are cross-sectional views sequentially illustrating a display area DA during a process of fabricating a display device according to an embodiment. Specifically, FIGS. 14 through 24 schematically illustrate a process of forming a bank structure 160 and light emitting elements ED of a display device 10. In the following description of the process of fabricating the display device 10, the formation process of each layer will not be described, and the formation order of each layer will be described.

Referring to FIG. 14, a plurality of pixel electrodes AE1 through AE3, sacrificial layers SFL, an inorganic pixel defining layer 151, and a plurality of bank material layers 161L and 163L are formed on a thin-film transistor layer 130.

Although not illustrated in the drawing, the thin-film transistor layer 130 may be disposed on a substrate 110. The structure of the thin-film transistor layer 130 is the same as that described above with reference to FIG. 7, and thus a detailed description thereof will be omitted.

The pixel electrodes AE1 through AE3 may be spaced apart from each other on the thin-film transistor layer 130. The pixel electrodes AE1 through AE3 may include a first pixel electrode AE1, a second pixel electrode AE2, and a third pixel electrode AE3 of different light emitting elements ED1 through ED3. The first through third pixel electrodes AE1 through AE3 may be spaced apart from each other on the thin-film transistor layer 130.

The sacrificial layers SFL may be disposed on the pixel electrodes AE1 through AE3. The sacrificial layers SFL disposed on the pixel electrodes AE1 through AE3 may be partially removed in a subsequent process to form spaces in which light emitting layers EL1 through EL3 are to be disposed. The sacrificial layers SFL may prevent upper surfaces of the pixel electrodes AE1 through AE3 from contacting the inorganic pixel defining layer 151. The sacrificial layers SFL may be removed in a subsequent process to form spaces between the pixel electrodes AE1 through AE3 and the inorganic pixel defining layer 151. In an embodiment, the sacrificial layers SFL may include an oxide semiconductor. In an embodiment, for example, the sacrificial layers SFL may include at least one of indium gallium zinc oxide ("IGZO"), zinc tin oxide ("ZTO"), and indium tin oxide (ITO).

The inorganic pixel defining layer 151 and the bank material layers 161L and 163L may be disposed on the sacrificial layers SFL. The inorganic pixel defining layer 151 may be disposed to cover the entirety of the sacrificial layers SFL and the thin-film transistor layer 130, and the bank material layers 161L and 163L may be disposed to cover the entirety of the inorganic pixel defining layer 151. The bank material layers 161L and 163L may include a first bank material layer 161L and a second bank material layer 163L. The first bank material layer 161L may be directly disposed on the inorganic pixel defining layer 151, and the second bank material layer 163L may be disposed on the first bank material layer 161L. The bank material layers 161L and 163L may be partially etched in a subsequent process to form bank layers 161 and 163 of the bank structure 160 illustrated in FIG. 7, respectively. The bank material layers 161L and 163L are substantially the same as the bank layers 161 and 163 described above, and thus a detailed description thereof will be omitted.

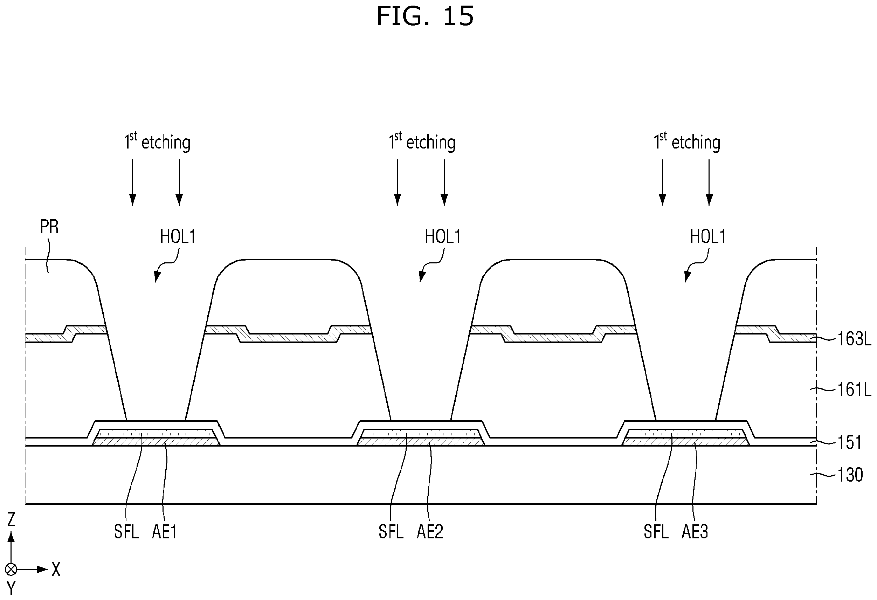

Next, referring to FIG. 15, photoresists PR are formed on the bank material layers 161L and 163L, and a first etching process for partially etching the bank material layers 161L and 163L is performed using the photoresists PR as a mask. In the current process, first holes HOL1 may be formed to overlap the pixel electrodes AE1 through AE3, respectively, in a plan view.

The photoresists PR may be spaced apart from each other on the bank material layers 161L and 163L. The photoresists PR may be disposed on the second bank material layer 163L to expose portions overlapping the pixel electrodes AE1 through AE3, respectively, in a plan view.

In an embodiment, the first etching process may be performed as dry etching. Since the first etching process is performed as a dry etching process, the bank material layers 161L and 163L including different materials may be etched. Therefore, the inorganic pixel defining layer 151 overlapping each of the pixel electrodes AE1 through AE3 may be exposed. The first holes HOL1 may be defined in areas overlapping the pixel electrodes AE1 through AE3 in a plan view. The first holes HOL1 may form openings of the bank structure 160.

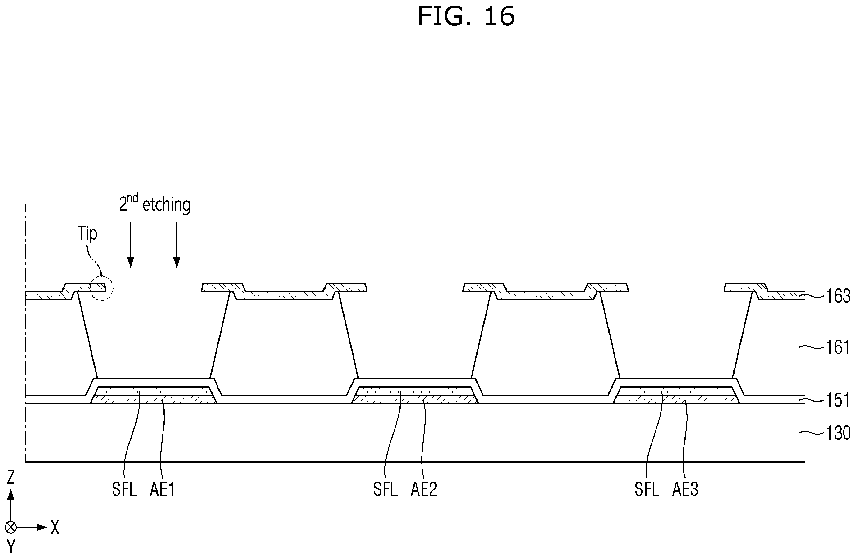

Next, referring to FIG. 16, a second etching process for forming tips TIP of the bank structure 160 is performed. In an embodiment, the second etching process may be performed as a wet etching process. In the current process, the first bank material layer 161L among the bank material layers 161L and 163L may be etched at a faster rate than the second bank material layer 163L. Accordingly, the tips TIP protruding more than side surfaces of the first bank material layer 161L may be formed on side surfaces of the second bank material layer 163L. Therefore, undercuts may be formed on the side surfaces of the first bank material layer 161L and under the tips TIP of the second bank material layer 163L.

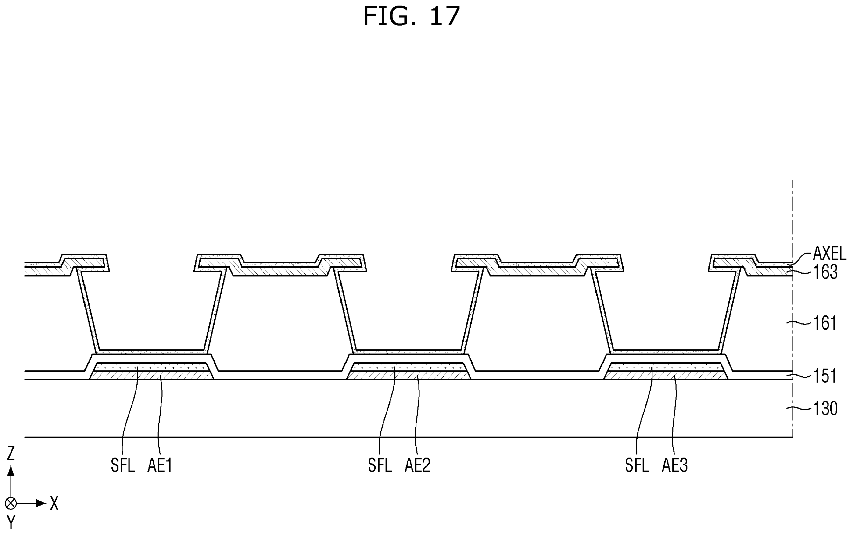

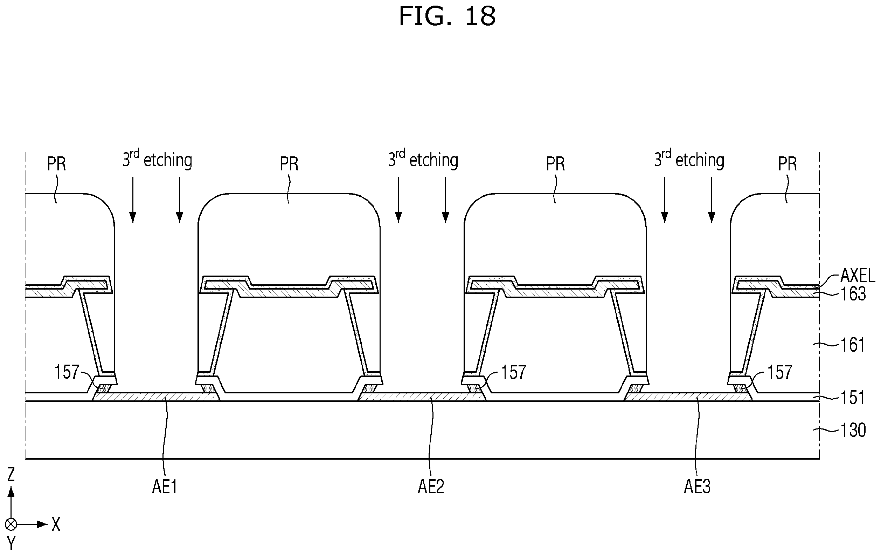

Next, referring to FIG. 17, an auxiliary electrode material layer AXEL may be formed on the second bank material layer 163L, the side surfaces of the first bank material layer 161L, and an upper surface of the inorganic pixel defining layer 151. In an embodiment, for example, the auxiliary electrode material layer AXEL may be formed by a sputtering process. As described above, the auxiliary electrode material layer AXEL may help common electrodes CE1 through CE3, which will be formed in a subsequent process, to be electrically connected to the bank structure 160. In a subsequent process of FIG. 18, the auxiliary electrode material layer AXEL may be formed into the above-described auxiliary electrodes AXE. The auxiliary electrode material layer AXEL is substantially the same as the above-described auxiliary electrodes AXE, and thus a detailed description thereof will be omitted.

Next, referring to FIG. 18, a third etching process for removing the auxiliary electrode material layer AXEL, the inorganic pixel defining layer 151 and the sacrificial layers SFL overlapping the pixel electrodes AE1 through AE3 in a plan view is performed. Specifically, in the third etching process, a dry etching process and a wet etching process may be alternately performed. Specifically, first, the auxiliary electrode material layer AXEL including a conductive metal may be removed through a wet etching process. Accordingly, portions of the auxiliary electrode material layer AXEL overlapping each of the pixel electrodes AE1 through AE3 in a plan view may be removed, and the inorganic pixel defining layer 151 overlapping each of the pixel electrodes AE1 through AE3 in a plan view may be exposed.

Second, the inorganic pixel defining layer 151 including an inorganic layer may be removed through a dry etching process. Accordingly, portions of the inorganic pixel defining layer 151 overlapping each of the pixel electrodes AE1 through AE3 in a plan view may be removed, and the sacrificial layers SFL overlapping the pixel electrodes AE1 through AE3, respectively, may be exposed.

Third, the sacrificial layers SFL including an oxide semiconductor may be removed through a wet etching process. In the current process, the sacrificial layers SFL between the inorganic pixel defining layer 151 and the pixel electrodes AE1 through AE3 may be removed. However, the sacrificial layers SFL may not be completely removed but may remain as residual patterns 157 between the inorganic pixel defining layer 151 and the pixel electrodes AE1 through AE3. As portions formed by the removal of the sacrificial layers SFL, spaces may be formed between the pixel electrodes AE1 through AE3 and the inorganic pixel defining layer 151 disposed on the pixel electrodes AE1 through AE3. In a subsequent process, the light emitting layers EL1 through EL3 may be formed on the pixel electrodes AE1 through AE3 to fill the spaces.

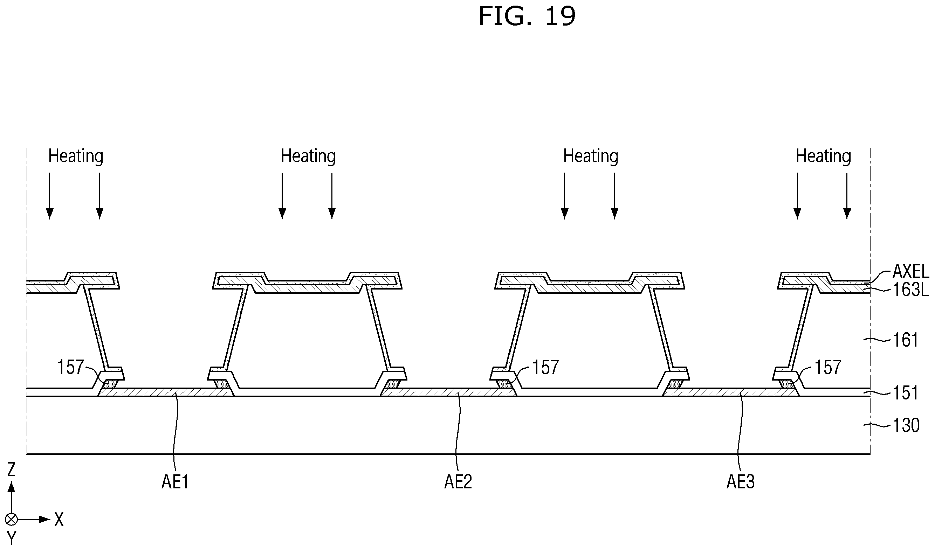

Next, referring to FIG. 19, high-temperature heat treatment may be performed on the auxiliary electrodes AXE located on the bank structure 160. Therefore, the auxiliary electrodes AXE may include a crystallized transparent oxide. In an embodiment, for example, the auxiliary electrodes AXE may include polymerized indium-tin-oxide (ITO).

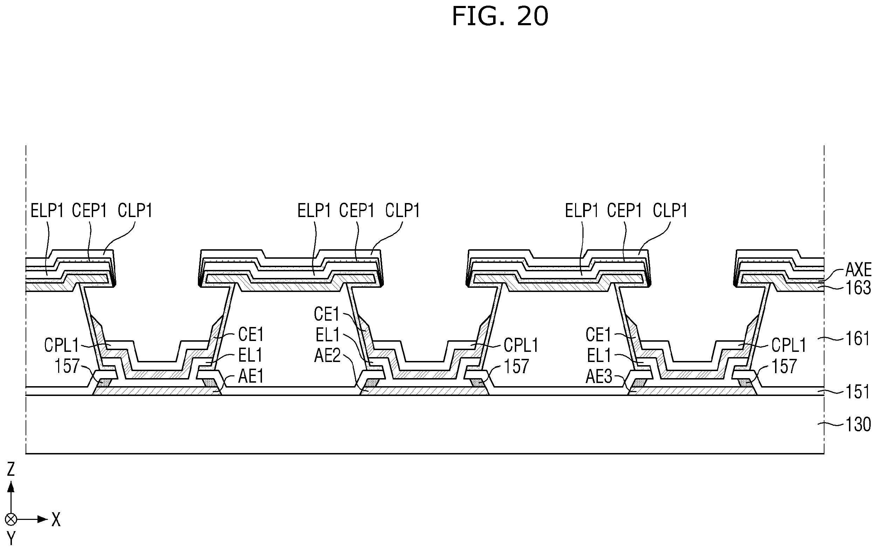

Next, referring to FIG. 20, a first light emitting layer EL1, a first common electrode CE1, and a first capping layer CPL1 may be deposited on each of the pixel electrodes AE1 through AE3. The first light emitting layer EL1, the first common electrode CE1, and the first capping layer CPL1 may be formed not only on the first pixel electrode AE1 but also on the second pixel electrode AE2 and the third pixel electrode AE3.

In addition, in the deposition process, materials that form the first light emitting layer EL1, the first common electrode CE1, and the first capping layer CPL1 may also be deposited on the second bank material layer 163L to form a plurality of patterns. In an embodiment, for example, some of the materials may be deposited on the second bank material layer 163L to form a first organic pattern ELP1, a first electrode pattern CEP1, and a first capping pattern CLP1. The structures and relationships of the first light emitting layer EL1, the first common electrode CE1 and the first capping layer CPL1 with the first organic pattern ELP1, the first electrode pattern CEP1 and the first capping pattern CLP1 are the same as those described above, and thus a description thereof will be omitted.

As described above with reference to FIG. 10, the light emitting layers EL1 through EL3 may be deposited at a first angle with respect to the upper surfaces of the pixel electrodes AE1 through AE3, and the common electrodes CE1 through CE3 may be deposited at a second angle with respect to the upper surfaces of the pixel electrodes AE1 through AE3. Therefore, they may be smoothly deposited even under the tips TIP of the second bank material layer 163L. As described above, since the second angle includes a smaller value than the first angle, a deposition process for forming the common electrodes CE1 through CE3 may be performed at an angle relatively closer to a horizontal direction (e.g., X-axis direction or Y-axis direction) than the angle of a deposition process for forming the light emitting layers EL1 through EL3. Accordingly, the common electrodes CE1 through CE3 may contact the first bank material layer 161L over a larger area than the light emitting layers EL1 through EL3. In other words, the common electrodes CE1 through CE3 may be deposited to a higher position on the side surfaces of the first bank material layer 161L than the light emitting layers EL1 through EL3. The common electrodes CE1 through CE3 formed at different locations may contact the highly conductive first bank material layer 161L and thus may be electrically connected to each other.

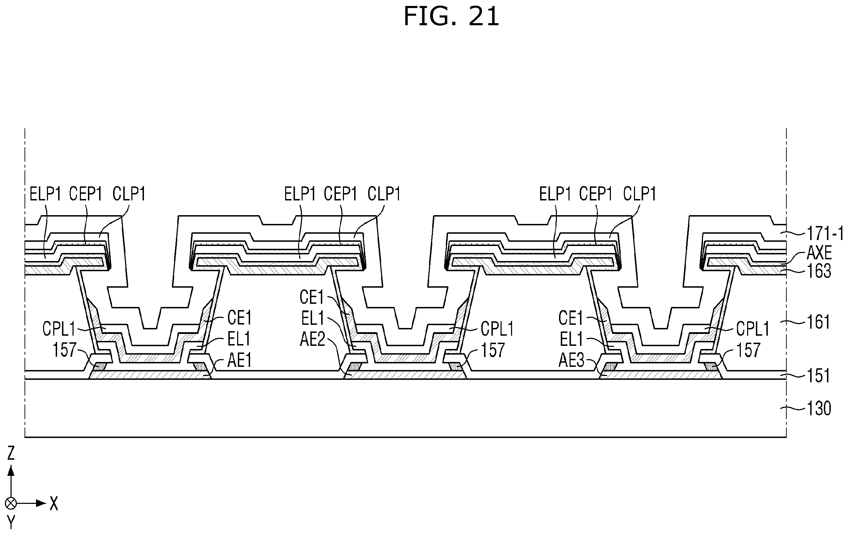

Next, referring to FIG. 21, a first inorganic layer 171-1 is formed to cover the first capping layer CPL1 and the first capping pattern CLP1. The first inorganic layer 171-1 may be formed to overlap each of the pixel electrodes AE1 through AE3 in a plan view. Unlike the light emitting layers EL1 through EL3 and the common electrodes CE1 through CE3, the first inorganic layer 171-1 may be formed by a CVD process. The first inorganic layer 171-1 may form a uniform layer regardless of a step of a portion where it is deposited. That is, the first inorganic layer 171-1 may cover a structure thereunder to a uniform thickness along the profile of the structure.

The first inorganic layer 171-1 may completely cover the first capping layer CPL1, the side surfaces of the first bank material layer 161L, and the first capping pattern CLP1. In particular, the first inorganic layer 171-1 may also be deposited under the tips TIP of the second bank material layer 163L.

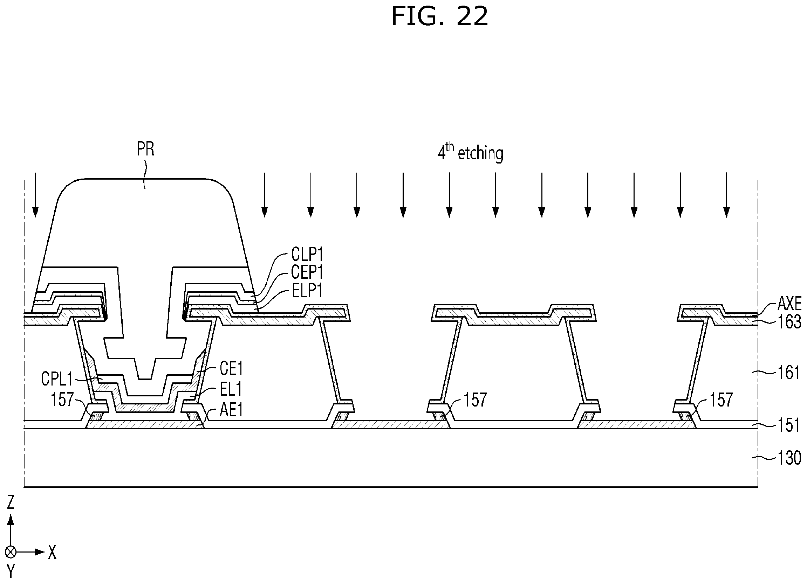

Next, referring to FIG. 22, a photoresist PR is formed on the bank material layers 161L and 163L located on the first pixel electrode AE1 and opposite sides of the first pixel electrode AE1, and then a fourth etching process is performed.

In the current process, the first light emitting layer EL1, the first common electrode CE1, the first capping layer CPL1, the patterns ELP1, CEP1 and CLP1, and the first inorganic layer 171-1 in portions where the photoresist PR is not formed may all be removed except for a portion around the first pixel electrode AE1. In an embodiment, the process of removing all portions except for the portion around the first pixel electrode AE1 may be performed as a dry etching process using a fluorine (F)-based etchant. Through the above process, the first inorganic layer 171-1 covering a first light emitting element ED1, the first capping layer CPL1, the first organic pattern ELP1, the first electrode pattern CEP1, and the first capping pattern CLP1 as illustrated in FIG. 7 may be formed.

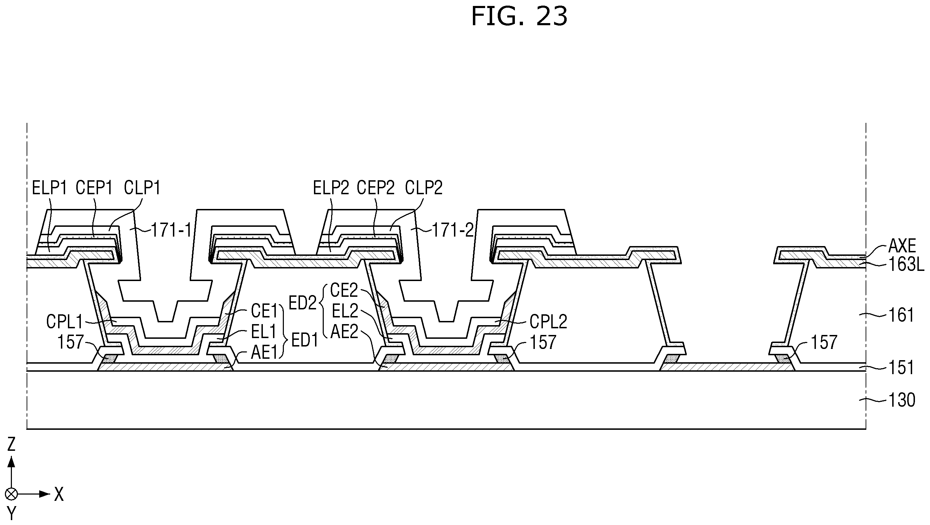

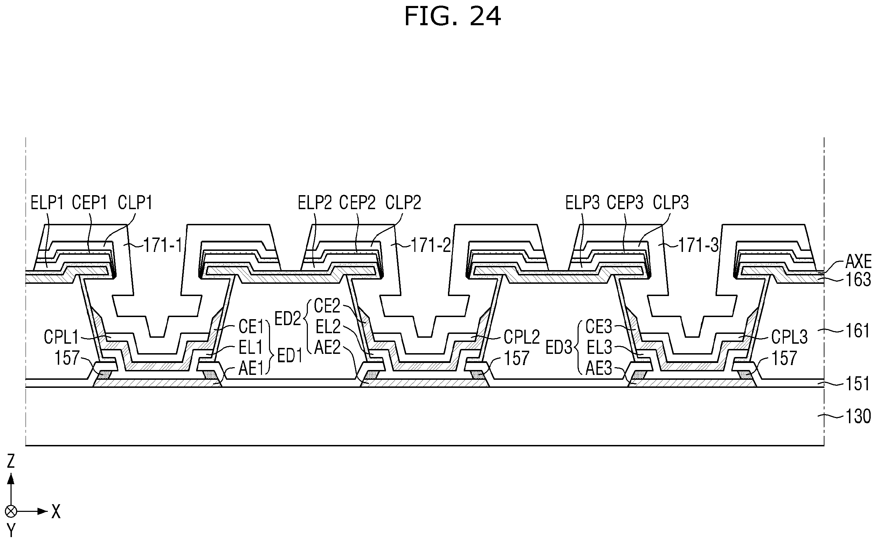

Referring to FIGS. 23 and 24, processes similar to the above-described processes may be repeated to form a second light emitting element ED2, a third light emitting element ED3, a second inorganic layer 171-2, and a third inorganic layer 171-3.

Although not illustrated in the drawings, a thin-film encapsulation layer 170 may be formed by forming a second encapsulation layer 173 and a third encapsulation layer 175 on a first encapsulation layer 171 and the bank structure 160. Then, a touch sensor layer 180, a light blocking layer BM, a color filter layer 190, and an overcoat layer OC may be formed to produce the display device 10.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

However, the effects of the present disclosure are not restricted to the one set forth herein. The above and other effects of the present disclosure will become more apparent to one of daily skill in the art to which the present disclosure pertains by referencing the claims.

## Claims

1. A display device comprising:
a substrate comprising an emission area and a non-emission area;
a pixel electrode located on the emission area of the substrate;
a pixel defining layer located on the pixel electrode, overlapping the non-emission area, and defining a first opening therein;
a bank structure located on the pixel defining layer and defining a second opening therein;
an auxiliary electrode located on the bank structure and comprising a conductive material; and
a common electrode located on the pixel electrode and contacting the auxiliary electrode in the second opening,
wherein the bank structure comprises a first bank layer and a second bank layer, which comprise different conductive materials from each other, the second bank layer comprises a tip protruding toward the first opening from a side surface of the first bank layer, and the auxiliary electrode completely covers the protruding tip of the second bank layer.

2. The display device of claim 1, wherein the second bank layer comprises a first surface facing the substrate, a second surface opposite to the first surface, and a side surface facing the first opening and connecting the first surface and the second surface, and
wherein the auxiliary electrode overlaps the protruding tip of the second bank layer to contact the first surface, the side surface, and the second surface.

3. The display device of claim 2, wherein the auxiliary electrode contacts and completely covers the second surface of the second bank layer.

4. The display device of claim 3, wherein the auxiliary electrode contacts and completely covers the side surface of the first bank layer, optionally wherein the bank structure is completely surrounded by the pixel defining layer and the auxiliary electrode.

5. The display device of claim 3 or claim 4, wherein the auxiliary electrode is a crystallized transparent oxide, optionally wherein the first bank layer comprises aluminium (Al), and the second bank layer comprises titanium (Ti).

6. The display device of any one of claims 1 to 5, further comprising a light emitting layer located between the pixel electrode and the common electrode, wherein the light emitting layer contacts the auxiliary electrode in the second opening.

7. The display device of claim 6, wherein the auxiliary electrode comprises a first portion in contact with the light emitting layer and a second portion in contact with the common electrode, and a width of the second portion is greater than a width of the first portion in a direction perpendicular to a major surface of the substrate.

8. The display device of claim 6 or claim 7, further comprising:
an organic pattern overlapping the protruding tip of the second bank layer, located on the auxiliary electrode, and comprising a same material as the light emitting layer; and
an electrode pattern located on the organic pattern and comprising a same material as the common electrode,
wherein the organic pattern is spaced apart from the light emitting layer, and the electrode pattern is spaced apart from the common electrode.

9. The display device of claim 8, further comprising an encapsulation layer located on the common electrode and the electrode pattern, wherein the encapsulation layer contacts the auxiliary electrode on the side surface of the first bank layer, optionally wherein the display device further comprises a pattern located between the pixel defining layer and the pixel electrode and overlapping the protruding tip of the second bank layer in a direction perpendicular to a major surface of the substrate, wherein the pattern overlaps the auxiliary electrode in the direction perpendicular to the major surface of the substrate.

10. A display device comprising:
a substrate comprising a first emission area, a second emission area, and a non-emission area located between the first emission area and the second emission area;
a first pixel electrode overlapping the first emission area and located on the substrate;
a pixel defining layer overlapping the non-emission area and located on the first pixel electrode;
a second pixel electrode overlapping the second emission area and spaced apart from the first pixel electrode with the pixel defining layer interposed therebetween;
a bank structure located on the pixel defining layer; and
an auxiliary electrode located on the pixel defining layer and the bank structure,
wherein the auxiliary electrode comprises:
a first portion overlapping the first emission area;
a second portion overlapping the second emission area; and
a third portion overlapping the non-emission area,
wherein the first portion and the second portion of the auxiliary electrode are extended from the third portion, and the third portion of the auxiliary electrode completely covers an upper surface of the bank structure.

11. The display device of claim 10, wherein the bank structure comprises a first bank layer and a second bank layer, the second bank layer comprises tips, which protrude from side surfaces of the first bank layer toward the first emission area and the second emission area, respectively, and the first portion and the second portion of the auxiliary electrode completely cover the protruding tips of the second bank layer, respectively.

12. The display device of claim 11, further comprising:
a first common electrode located on the first pixel electrode; and
a second common electrode located on the second pixel electrode,
wherein the first common electrode and the second common electrode are spaced apart from each other with the bank structure interposed therebetween, the first common electrode contacts the first portion of the auxiliary electrode, and the second common electrode contacts the second portion of the auxiliary electrode.

13. The display device of claim 12, further comprising:
a first inorganic layer covering the first common electrode; and
a second inorganic layer covering the second common electrode,
wherein the first inorganic layer and the second inorganic layer overlap the third portion of the auxiliary electrode and are spaced apart from each other, optionally wherein the display device further comprises an organic encapsulation layer located on the first inorganic layer and the second inorganic layer, wherein the third portion of the auxiliary electrode contacts the organic encapsulation layer.

14. A method of fabricating a display device, the method comprising:
forming a plurality of pixel electrodes spaced apart from each other on a substrate, a sacrificial layer disposed on the pixel electrodes, a pixel defining layer disposed on the sacrificial layer, and a first bank material layer and a second bank material layer disposed on the pixel defining layer;
forming first holes overlapping the pixel electrodes and passing through the first bank material layer and the second bank material layer to expose the pixel defining layer disposed on the pixel electrodes;
forming tips of the second bank material layer, which protrude from sidewalls of the first bank material layer through wet-etching sidewalls of the first holes;
forming an auxiliary electrode material layer covering the pixel defining layer, the first bank material layer, and the second bank material layer;
forming openings by removing portions of the auxiliary electrode material layer, which overlap the pixel electrodes through wet-etching, removing portions of the pixel defining layer, which overlap the pixel electrodes through dry-etching and removing portions of the sacrificial layer, which overlap the pixel electrodes through wet-etching and exposing the pixel electrodes overlapping the openings;
performing heat treatment on the auxiliary electrode material layer covering the first bank material layer and the second bank material layer;
forming a light emitting layer and a common electrode on each of the pixel electrodes in the openings and forming an inorganic layer on the common electrode and the auxiliary electrode material layer; and
partially removing portions of the inorganic layer, which are disposed on the auxiliary electrode material layer,
wherein the auxiliary electrode material layer completely covers the protruding tips of the second bank material layer.

15. The method of claim 14, wherein the auxiliary electrode material layer becomes a crystallized transparent oxide through the heat treatment, optionally wherein the first bank material layer and the second bank material layer are completely surrounded by the pixel defining layer and the auxiliary electrode material layer.
